# EUROPEAN PATENT APPLICATION

(11) **EP 4 510 802 A1**
(43) Date of publication of application: **19.02.2025**
(21) Application number: 24167004.1
(22) Date of filing: 27.03.2024
(51) Int. Cl.: H10B 12/00

(54) **SEMICONDUCTOR DEVICE**

(30) Priority: 14.08.2023 KR 20230106422
(71) Applicant: Samsung Electronics Co., Ltd., Suwon-si, Gyeonggi-do 16677 (KR)
(72) Inventor: CHO, Minhee, 16677 Suwon-si (KR); LEE, Hyeran, 16677 Suwon-si (KR); TERAI, Masayuki, 16677 Suwon-si (KR)
(74) Representative: Marks & Clerk LLP

(57) **Abstract**

A semiconductor device includes an upper conductive line extending in a first horizontal direction over a substrate, a channel layer facing the upper conductive line in a second horizontal direction that is perpendicular to the first horizontal direction, a gate dielectric film between the channel layer and the upper conductive line, a conductive contact pattern including a lower surface, which is in contact with an upper surface of the channel layer, and sidewalls including a first sidewall, which faces the upper conductive line in the second horizontal direction, and an insulating spacer including a first portion between the upper conductive line and the conductive contact pattern in the second horizontal direction.

## Description

### BACKGROUND

Apparatuses and devices consistent with the present disclosure to a semiconductor device, and more particularly, to a semiconductor device including a channel layer that includes an oxide semiconductor.

Due to the advance of the electronics technology, semiconductor devices have been rapidly down-scaled, and thus, transistors including channel layers that include oxide semiconductor materials have been proposed to reduce leakage current through channel regions.

### SUMMARY

It is an aspect to provide a semiconductor device with a structure having improved reliability by ensuring an electrical connection between a channel layer and a conductive contact pattern contacting the channel layer in a transistor including the channel layer, which includes an oxide semiconductor material, and by preventing a short-circuit between other conductive components adjacent to the channel layer and the conductive contact pattern.

According to an aspect of one or more embodiments, there is provided a semiconductor device comprising an upper conductive line extending in a first horizontal direction over a substrate; a channel layer facing the upper conductive line in a second horizontal direction that is perpendicular to the first horizontal direction; a gate dielectric film between the channel layer and the upper conductive line; a conductive contact pattern comprising a lower surface, which is in contact with an upper surface of the channel layer, and sidewalls including a first sidewall, which faces the upper conductive line in the second horizontal direction; and an insulating spacer comprising a first portion between the upper conductive line and the conductive contact pattern in the second horizontal direction.

According to another aspect of one or more embodiments, there is provided a semiconductor device comprising a plurality of lower conductive lines arranged parallel to each other over a substrate; a mold insulating pattern arranged on the plurality of lower conductive lines and defining a transistor region that extends in a first horizontal direction; a plurality of channel layers arranged in a line in the first horizontal direction in the transistor region, each of the plurality of channel layers comprising a vertical channel portion that faces a sidewall of the mold insulating pattern; a plurality of upper conductive lines respectively arranged over the plurality of channel layers, each of the plurality of upper conductive lines having a sidewall that faces the vertical channel portion of a corresponding channel layer of the plurality of channel layers; a plurality of gate dielectric films respectively between the plurality of channel layers and the plurality of upper conductive lines; a plurality of conductive contact patterns connected to the vertical channel portion of a corresponding channel layer of the plurality of channel layers; and a plurality of insulating spacers respectively on the plurality of gate dielectric films, wherein each of the plurality of conductive contact patterns comprises a lower surface, which is in contact with an upper surface of the vertical channel portion, and a first sidewall facing a corresponding upper conductive line of the plurality of upper conductive lines, in a second horizontal direction that is perpendicular to the first horizontal direction, and each of the plurality of insulating spacers comprises a first portion between a corresponding upper conductive line of the plurality of upper conductive lines and a corresponding conductive contact pattern of the plurality of conductive contact patterns in the second horizontal direction.

According to yet another aspect of one or more embodiments, there is provided a semiconductor device comprising a peripheral circuit region arranged on a substrate and comprising a plurality of peripheral circuits; a lower conductive line arranged on the peripheral circuit region and connected to the plurality of peripheral circuits; a mold insulating pattern arranged on the lower conductive line and having a sidewall that defines a transistor region; a channel layer arranged in the transistor region and comprising an oxide semiconductor layer, the channel layer having a lower surface, which is in contact with an upper surface of the lower conductive line, and a vertical channel portion, which faces the sidewall of the mold insulating pattern; a gate dielectric film covering the channel layer in the transistor region; an upper conductive line arranged on the gate dielectric film in the transistor region and having a sidewall that faces the vertical channel portion, the upper conductive line extending in a first horizontal direction; a conductive contact pattern comprising a lower surface, which is in contact with an upper surface of the channel layer, and a first sidewall, which faces the upper conductive line in a second horizontal direction that is perpendicular to the first horizontal direction; and an insulating spacer comprising a first portion between the upper conductive line and the conductive contact pattern in the second horizontal direction.

At least some of the above and other features of the invention are set out in the claims.

### BRIEF DESCRIPTION OF THE DRAWINGS

Various embodiments will be more clearly understood from the following detailed description taken in conjunction with the accompanying drawings, in which:
FIG. 1 is a planar layout diagram illustrating some components of a semiconductor device according to some embodiments;
FIG. 2 is a cross-sectional view of the semiconductor device of FIG. 1, taken along a line A-A' of FIG. 1;
FIG. 3 is a cross-sectional view of the semiconductor device of FIG. 1, taken along a line B-B' of FIG. 1;
FIG. 4 is an enlarged cross-sectional view of a region EX1 of FIG. 2;
FIG. 5 is a cross-sectional view of a semiconductor device according to some embodiments;
FIG. 6 is an enlarged cross-sectional view of a region EX2 of FIG. 5;
FIG. 7 is a cross-sectional view of a semiconductor device according to some embodiments;
FIG. 8 is a cross-sectional view of a semiconductor device according to some embodiments;
FIG. 9 is an enlarged cross-sectional view of a region EX3 of FIG. 8;
FIG. 10 is a cross-sectional view of a semiconductor device according to some embodiments;

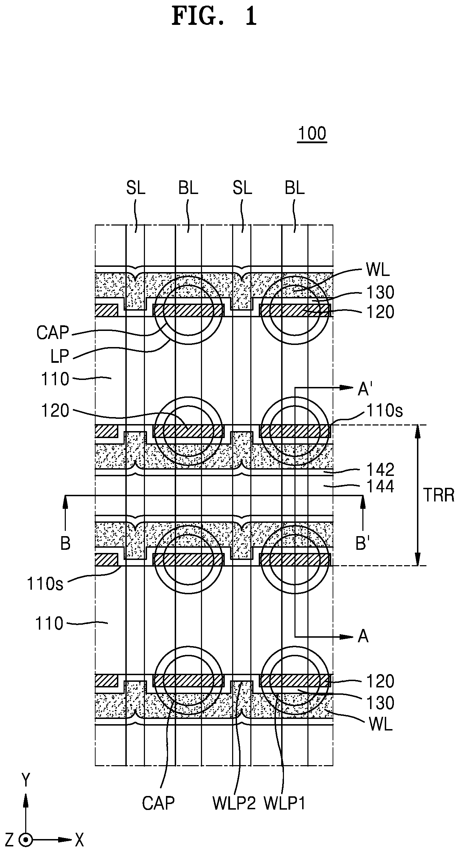

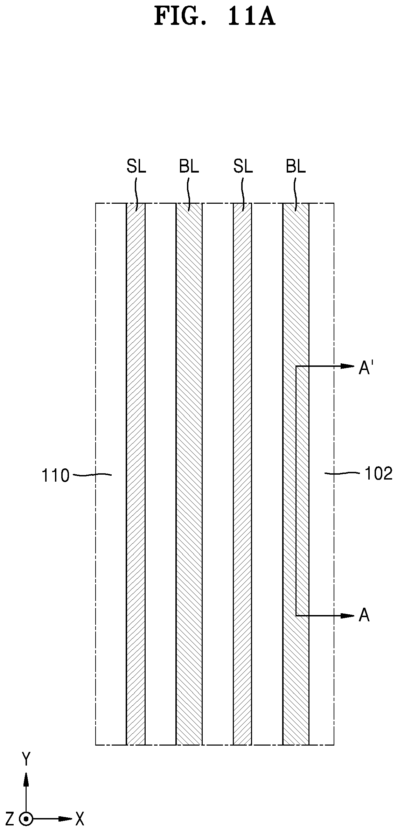

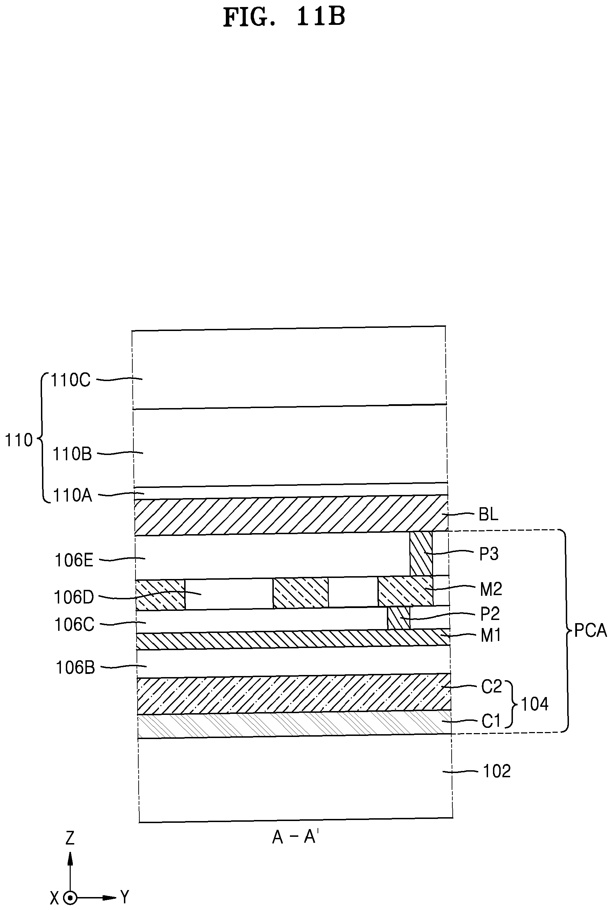

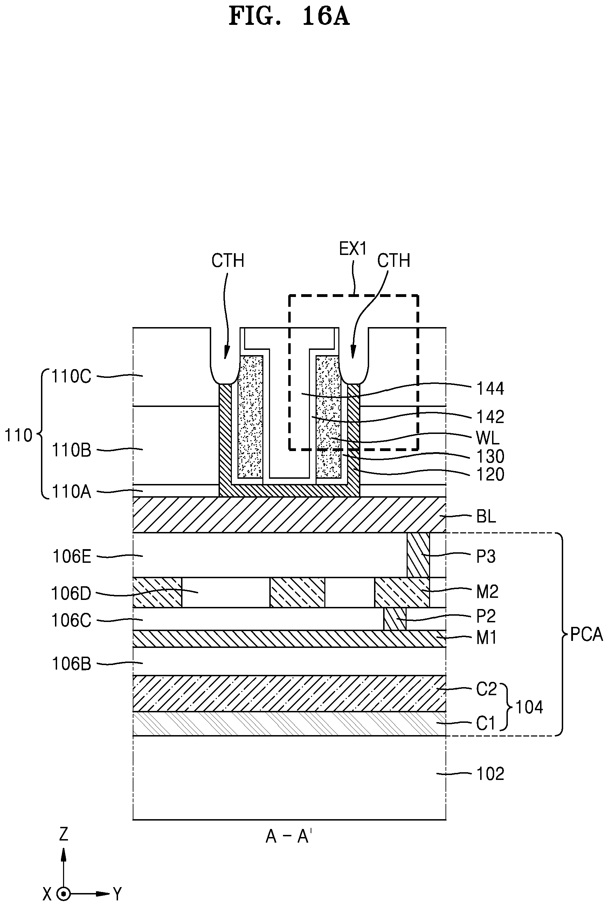

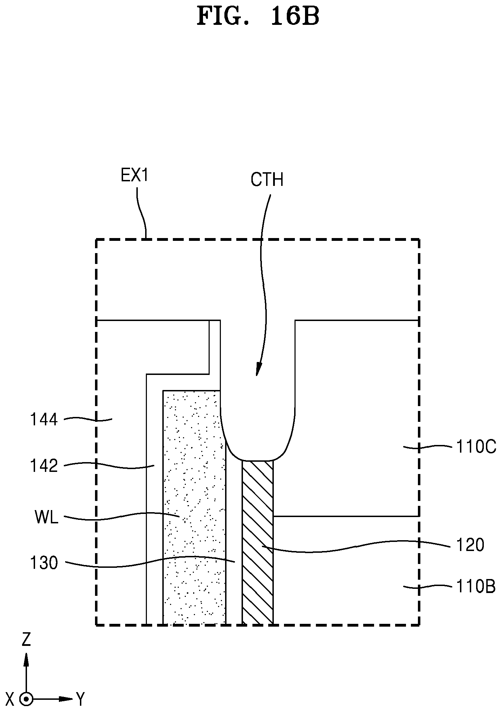

FIGS. 11A to 19B are diagrams respectively illustrating a sequence of processes of a method of fabricating a semiconductor device, according to some embodiments, and in particular, FIGS. 11A, 12A, and 15A are planar layout diagrams each illustrating some components of the semiconductor device according to the sequence of processes to describe the method of fabricating the semiconductor device, FIGS. 11B, 12B, 13, 14, 15B, 16A, 17A, 18A, and 19A are cross-sectional views each illustrating a portion of the semiconductor device, which corresponds to the cross-section taken along the line A-A' of FIG. 1, according to the sequence of processes, and FIGS. 16B, 17B, 18B, and 19B are enlarged cross-sectional views of regions EX1 of FIGS. 16A, 17A, 18A, and 19A, respectively;
FIGS. 20A to 24B are diagrams respectively illustrating a sequence of processes of a method of fabricating a semiconductor device, according to some embodiments, and in particular, FIGS. 20A, 21A, 22A, 23A, and 24A are cross-sectional views each illustrating a portion of the semiconductor device, which corresponds to the cross-section taken along the line A-A' of FIG. 1, according to the sequence of processes, and FIGS. 20B, 21B, 22B, 23B, and 24B are enlarged cross-sectional views of regions EX2 of FIGS. 20A, 21A, 22A, 23A, and 24A, respectively; and
FIG. 25A is a cross-sectional view illustrating a method of fabricating a semiconductor device, according to some embodiments, and FIG. 25B is an enlarged cross-sectional view of a region EX3 of FIG. 25A.

### DETAILED DESCRIPTION

Hereinafter, various embodiments will be described in detail with reference to the accompanying drawings. Like components are denoted by like reference numerals throughout the specification, and repeated descriptions thereof are omitted for conciseness. Additionally, in the drawings, some components may be enlarged with respect to other components in order to allow for more clear illustration and, as such, the drawings are should not be considered as being drawn to scale.

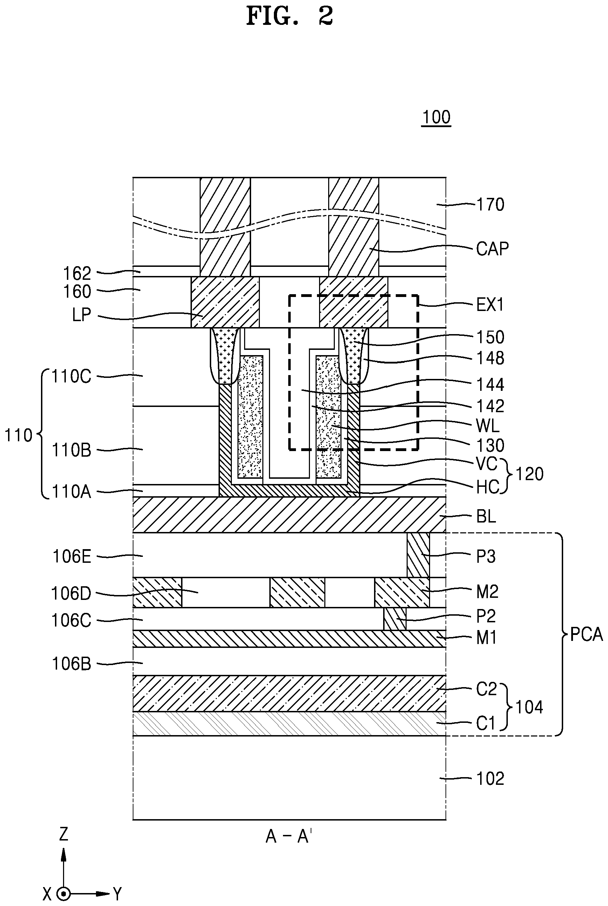

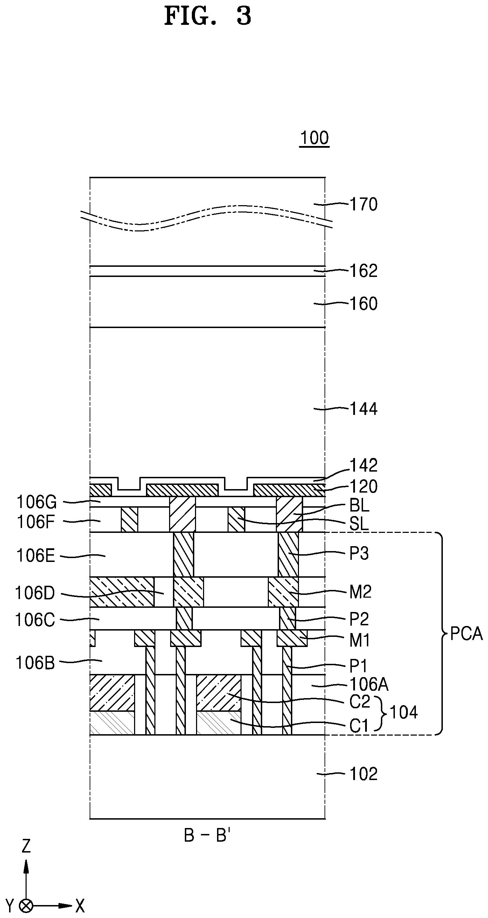

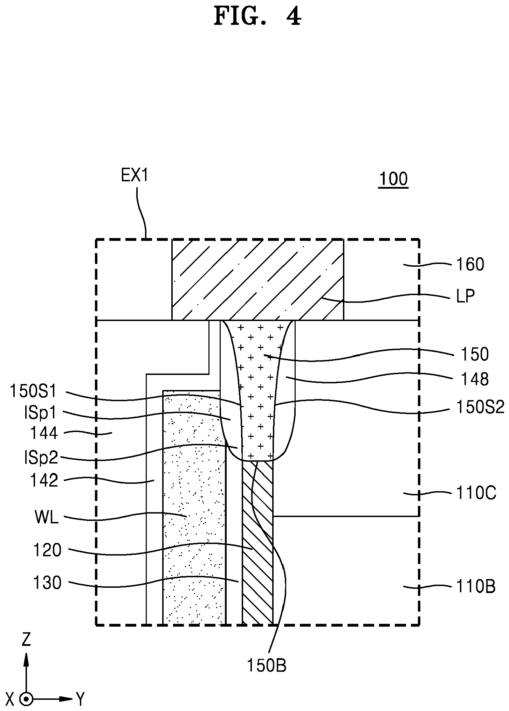

FIG. 1 is a planar layout diagram illustrating some components of a semiconductor device 100 according to some embodiments. FIG. 2 is a cross-sectional view of the semiconductor device 100 of FIG. 1, taken along a line A-A' of FIG. 1, FIG. 3 is a cross-sectional view of the semiconductor device 100 of FIG. 1, taken along a line B-B' of FIG. 1, and FIG. 4 is an enlarged cross-sectional view of a region EX1 of FIG. 2.

Referring to FIGS. 1 to 4, the semiconductor device 100 may include a substrate 102, a peripheral circuit structure PCA arranged on the substrate 102 and including a plurality of peripheral circuits, and a plurality of bit lines BL and a plurality of shielding structures SL, which are arranged on the peripheral circuit structure PCA.

In some embodiments, the substrate 102 may include silicon, for example, single-crystal silicon, polycrystalline silicon, or amorphous silicon. In some embodiments, the substrate 102 may include at least one selected from Ge, SiGe, SiC, GaAs, InAs, and InP. In some embodiments, the substrate 102 may include a conductive region, for example, an impurity-doped well or an impurity-doped structure.

Each of the plurality of bit lines BL may be connected to at least one peripheral circuit from among the plurality of peripheral circuits of the peripheral circuit structure PCA. Each of the plurality of shielding structures SL may be floating. The plurality of bit lines BL and the plurality of shielding structures SL may be insulated from each other by an interlayer dielectric 106F. The plurality of shielding structures SL may be covered by an interlayer dielectric 106G, and the plurality of bit lines BL may pass through the interlayer dielectrics 106F and 106G in the vertical direction (e.g., a Z direction). The plurality of bit lines BL may each be connected to a peripheral circuit of the peripheral circuit structure PCA through some of a plurality of conductive plugs P1, P2, and P3 and a plurality of wiring layers M1 and M2, which are included in the peripheral circuit structure PCA.

The peripheral circuit structure PCA may include a plurality of core circuits 104. The plurality of core circuits 104 may each include a first conductive pattern C1 and a second conductive pattern C2, which are sequentially arranged in the stated order on the substrate 102. The first conductive pattern C1 and the second conductive pattern C2 may constitute various circuit devices for controlling functions of a semiconductor device arranged on the peripheral circuit structure PCA. In some embodiments, the peripheral circuit structure PCA may further include various active elements, such as a transistor and the like, and various passive elements, such as a capacitor, a resistor, an inductor, and the like.

In some embodiments, the plurality of peripheral circuits of the peripheral circuit structure PCA may include, but are not limited to, a sub-word line driver (SWD) block, a sense amplifier (S/A) block, and/or control logic. The plurality of peripheral circuits of the peripheral circuit structure PCA may include an NMOS transistor and a PMOS transistor. The plurality of peripheral circuits may be electrically connected to conductive lines, for example, the plurality of bit lines BL, which are arranged on the peripheral circuit structure PCA, through the plurality of conductive plugs P1, P2, and P3 and the plurality of wiring layers M1 and M2.

In the peripheral circuit structure PCA, components required to be insulated from each other, from among the plurality of core circuits 104, the plurality of conductive plugs P1, P2, and P3, and the plurality of wiring layers M1 and M2, may maintain necessary insulating distances from each other by a plurality of interlayer dielectrics 106A, 106B, 106C, 106D, and 106E. Each of the plurality of interlayer dielectrics 106A, 106B, 106C, 106D, 106E, 106F, and 106G may include, but is not limited to, one of an oxide film, a nitride film, or a combination thereof.

In some embodiments, the peripheral circuit structure PCA on the substrate 102 may be omitted. In this case, the peripheral circuit structure PCA may be arranged on the substrate 102 in another area that is apart from the area shown in FIGS. 2 and 3. In some embodiments, the peripheral circuit structure PCA may be arranged in an area that is laterally apart from a cell array region including a transistor region TRR (see FIG. 1).

The plurality of bit lines BL and the plurality of shielding structures SL may be arranged over the substrate 102 to be spaced apart from each other in a first horizontal direction (e.g., an X direction) and extend lengthwise in a second first horizontal direction (e.g., a Y direction) that is perpendicular to the first horizontal direction (X direction). The plurality of bit lines BL and the plurality of shielding structures SL may extend parallel to each other in the second first horizontal direction (Y direction). In some embodiments, each of the plurality of bit lines BL may include, but is not limited to, one of Ti, TiN, Ta, TaN, Mo, Ru, W, WN, Co, Ni, TiSi, TiSiN, WSi, WSiN, TaSi, TaSiN, RuTiN, CoSi, NiSi, polysilicon, or a combination thereof. Herein, a bit line BL may be referred to as a lower conductive line. In some embodiments, each of the plurality of shielding structures SL may include, but is not limited to, one of W, Al, Cu, or a combination thereof. In some embodiments, each of the plurality of shielding structures SL may include a conductive film, which includes one of W, Al, Cu, or a combination thereof, and an air gap or a void in the conductive film.

A mold insulating pattern 110 may be arranged on or over the plurality of bit lines BL and the plurality of shielding structures SL. The mold insulating pattern 110 may have a sidewall 110s defining the transistor region TRR (see FIG. 1). Each of the mold insulating pattern 110 and the transistor region TRR defined by the sidewall 110s of the mold insulating pattern 110 may extend lengthwise in the first horizontal direction (X direction). The mold insulating pattern 110 may include a lower mold pattern 110A, a first mold insulating pattern 110B, and a second mold insulating pattern 110C, which are sequentially stacked in the stated order in the vertical direction (Z direction) on the plurality of bit lines BL and the interlayer dielectric 106G. Each of the lower mold pattern 110A, the first mold insulating pattern 110B, and the second mold insulating pattern 110C may include one of a silicon oxide film, a silicon nitride film, or a combination thereof. For example, in some embodiments, the lower mold pattern 110A and the second mold insulating pattern 110C may each include a silicon nitride film, and the first mold insulating pattern 110B may include a silicon oxide film. However, embodiments are not limited thereto and, in some embodiments, each of the of the lower mold pattern 110A, the first mold insulating pattern 110B, and the second mold insulating pattern 110C may include a same material.

As shown in FIGS. 1 and 2, in the transistor region TRR, a plurality of channel layers 120 may be arranged in a line in the first horizontal direction (X direction). Each of the plurality of channel layers 120 may include a vertical channel portion VC, which faces the sidewall of the mold insulating pattern 110, and a horizontal channel portion HC, which is in contact with the upper surface of the bit line BL. In each of the plurality of channel layers 120, the vertical channel portion VC may be in contact with the sidewall of the mold insulating pattern 110 and may extend lengthwise in the vertical direction (Z direction) from the horizontal channel portion HC. In one example, the device may comprise an upper conductive line extending in a first horizontal direction over a substrate, and a channel layer facing the upper conductive line in a second horizontal direction that is perpendicular to the first horizontal direction.

In the transistor region TRR, a plurality of transistors respectively including the plurality of channel layers 120 may be arranged. The plurality of transistors may include two transistors facing each other in the second horizontal direction (Y direction), which is perpendicular to the first horizontal direction (X direction), and the two transistors may share one channel layer 120 of the plurality of channel layers 120. Each of the plurality of channel layers 120 may be in contact with the upper surface of one bit line BL of the plurality of bit lines BL.

In some embodiments, the channel layer 120 may include an oxide semiconductor layer including one of InGaZnO (IGZO), Sn-IGZO, InWO (IWO), InZnO (IZO), ZnSnO (ZTO), ZnO, yttrium-doped zinc oxide (YZO), InGaSiO (IGSO), InO, SnO, TiO, ZnON, MgZnO, ZrInZnO, HfInZnO, SnInZnO, SiInZnO, GaZnSnO, ZrZnSnO, or a combination thereof. In some embodiments, the channel layer 120 may include one of Si, Ge, SiGe, a Group III-V compound semiconductor, or a combination thereof. The Group III-V compound semiconductor may include, but is not limited to, GaAs or InSb. For example, the channel layer 120 may include IGZO.

As shown in FIGS. 1 and 2, a gate dielectric film 130, which covers the channel layer 120, and a plurality of word lines WL, which cover the gate dielectric film 130, may be arranged in the transistor region TRR. The plurality of word lines WL may be arranged parallel to each other in the second horizontal direction (Y direction) and extend lengthwise in the first horizontal direction (X direction). Herein, a word line WL may be referred to as an upper conductive line. In the transistor region TRR, one word line WL may be in contact with one gate dielectric film 130. Each of the plurality of channel layers 120 may face the word line WL in the second horizontal direction (Y direction) with the gate dielectric film 130 therebetween.

As shown in FIG. 1, each of the plurality of word lines WL may include a portion WLP1, which faces the channel layer 120 in the second horizontal direction (Y direction) with the gate dielectric film 130 therebetween, and a portion WLP2, which faces the mold insulating pattern 110 in the second horizontal direction (Y direction) with the gate dielectric film 130 therebetween. In one example, a gate dielectric film may be between the channel layer and the upper conductive line.

As shown in FIG. 2, the bit line BL may be spaced apart from the word line WL in the vertical direction (Z direction) with the channel layer 120 and the gate dielectric film 130 therebetween. The bit line BL may have an upper surface contacting the channel layer 120.

One channel layer 120 may face surfaces of each of two word lines WL. The gate dielectric film 130 may be arranged between the channel layer 120 and the word line WL. The gate dielectric film 130 may include a vertical portion between the word line WL and the vertical channel portion VC of the channel layer 120 and a horizontal portion between the word line WL and the horizontal channel portion HC of the channel layer 120.

In some embodiments, the gate dielectric film 130 may include a high-K film having a dielectric constant that is higher than a dielectric constant of a silicon oxide film. In some embodiments, the gate dielectric film 130 may include at least one material selected from hafnium oxide (HfO), hafnium silicate (HfSiO), hafnium oxynitride (HfON), hafnium silicon oxynitride (HfSiON), lanthanum oxide (LaO), lanthanum aluminum oxide (LaAlO), zirconium oxide (ZrO), zirconium silicate (ZrSiO), zirconium oxynitride (ZrON), zirconium silicon oxynitride (ZrSiON), tantalum oxide (TaO), titanium oxide (TiO), barium strontium titanium oxide (BaSrTiO), barium titanium oxide (BaTiO), lead zirconate titanate (PZT), strontium bismuth tantalate (STB), bismuth iron oxide (BFO), strontium titanium oxide (SrTiO), yttrium oxide (YO), aluminum oxide (AlO), and lead scandium tantalum oxide (PbScTaO). Each of the plurality of word lines WL may include one of Ti, TiN, Ta, TaN, Mo, Ru, W, WN, TiSiN, WSiN, polysilicon, or a combination thereof.

In the transistor region TRR, a lower insulating liner 142 and an upper insulating partition wall 144 may be arranged on or over the channel layer 120 between two word lines WL that are adjacent to each other and spaced apart from each other in the second horizontal direction (Y direction). The lower insulating liner 142 and the upper insulating partition wall 144 may respectively include insulating films including different materials from each other. For example, in some embodiments, the lower insulating liner 142 may include a silicon nitride film and the upper insulating partition wall 144 may include a silicon oxide film, but embodiments are not limited thereto.

A plurality of conductive contact patterns 150 may be respectively arranged on the plurality of channel layers 120. Each of the plurality of conductive contact patterns 150 may be connected to one channel layer 120 of the plurality of channel layers 120. Each of the plurality of conductive contact patterns 150 may include a lower surface 150B contacting the upper surface of the vertical channel portion VC of the channel layer 120, a first sidewall 150S1 facing the word line WL in the second horizontal direction (Y direction), and a second sidewall 150S2 facing the mold insulating pattern 110 in the second horizontal direction (Y direction). The first sidewall 150S1 and the second sidewall 150S2 of the conductive contact pattern 150 may be on opposite sides to each other in the second horizontal direction (Y direction). In one example, a conductive contact pattern may comprise a lower surface, which is in contact with an upper surface of the channel layer, and sidewalls including a first sidewall, which faces the upper conductive line in the second horizontal direction. In one example, the sidewalls of the conductive contact pattern may further comprise a second sidewall, which is on an opposite side to the first sidewall in the second horizontal direction.

Each of the plurality of conductive contact patterns 150 may include a metal-containing film. In some embodiments, each of the plurality of conductive contact patterns 150 may include one of Ti, TiN, Ta, TaN, Mo, Ru, W, WN, TiSiN, WSiN, Ni, Ru, or a combination thereof. For example, each of the plurality of conductive contact patterns 150 may have a stack structure of a conductive barrier film including TiN and a conductive film including W.

An insulating spacer 148 may be located between the word line WL and the conductive contact pattern 150 in the second horizontal direction (Y direction). The insulating spacer 148 may be arranged on the gate dielectric film 130. The insulating spacer 148 may include a first portion ISp1 between the word line WL and the conductive contact pattern 150 and a second portion ISp2 between the gate dielectric film 130 and the conductive contact pattern 150. The insulating spacer 148 may surround sidewalls of the conductive contact pattern 150 such that the insulating spacer 148 is in contact with each of the first sidewall 150S1 and the second sidewall 150S2 of the conductive contact pattern 150 in the second horizontal direction (Y direction). In some embodiments, the insulating spacer 148 may have a ring shape surrounding the conductive contact pattern 150 when viewed in a plane (the X-Y plane in FIGS. 1 to 4). In some embodiments, the conductive contact pattern 150 may be spaced apart from the mold insulating pattern 110 in the second horizontal direction (Y direction) with the insulating spacer 148 therebetween. In one example, an insulating spacer may comprise a first portion between the upper conductive line and the conductive contact pattern in the second horizontal direction. In one example, the insulating spacer may surround the sidewalls of the conductive contact pattern such that the insulating spacer is in contact with each of the first sidewall and the second sidewall of the conductive contact pattern. In one example, the insulating spacer may surround only some of the sidewalls of the conductive contact pattern such that the insulating spacer is in contact with the first sidewall of the conductive contact pattern and is not in contact with the second sidewall of the conductive contact pattern. In one example, the insulating spacer may further comprise a second portion between the gate dielectric film and the conductive contact pattern.

In some embodiments, the insulating spacer 148 may include one of silicon oxide, silicon nitride, SiCN, SiBN, SiON, SiOCN, SiBCN, SiOC, or a combination thereof. As used herein, each of the terms "SiCN", "SiBN", "SiON", "SiOCN", "SiBCN", and "SiOC" refers to a material including elements contained in each term and is not a chemical formula representing a stoichiometric relationship.

In one example, the channel layer may comprise a vertical channel portion, which is in contact with the mold insulating pattern and extends in a vertical direction in the transistor region and the conductive contact pattern may be in contact with the mold insulating pattern. In one example, the conductive contact pattern may be spaced apart from the mold insulating pattern in the second horizontal direction with the insulating spacer therebetween. In one example, the mold insulating pattern may comprise a first mold insulating pattern and a second mold insulating pattern, which are sequentially stacked in a vertical direction and comprise different materials from each other, and the conductive contact pattern may be in contact with each of the first mold insulating pattern and the second mold insulating pattern.

As shown in FIG. 1, the plurality of channel layers 120, and thus the plurality of conductive contact patterns 150, may be regularly arranged at regular intervals in the first horizontal direction (X direction) and the second horizontal direction (Y direction). Although FIG. 1 illustrates an example in which the plurality of channel layers 120, and thus the plurality of conductive contact patterns 150, are arranged in a matrix structure in a plane (for example, the X-Y plane) over the substrate102, embodiments are not limited thereto. For example, the plurality of channel layers 120, and thus the plurality of conductive contact patterns 150, may be arranged in a honeycomb structure in a plane (for example, the X-Y plane) over the substrate 102. A plurality of conductive landing pads LP may be respectively arranged on the plurality of channel layers 120 and thus, on the plurality of conductive contact patterns 150. Each of the plurality of conductive landing pads LP may be connected to a corresponding conductive contact pattern 150 of the plurality of conductive contact patterns 150. The plurality of conductive landing pads LP may be insulated from each other by an isolation insulating film 160. In some embodiments, each of the plurality of conductive landing pads LP may include a metal-containing film. In some embodiments, each of the plurality of conductive landing pads LP may include one of Ti, TiN, Ta, TaN, Mo, Ru, W, WN, TiSiN, WSiN, Ni, Ru, or a combination thereof.

The semiconductor device 100 may further include a plurality of capacitor structures CAP respectively arranged on the plurality of conductive landing pads LP. An etch stop film 162 and an interlayer dielectric 170 may be sequentially stacked in the stated order on the plurality of conductive landing pads LP and the isolation insulating film 160. Each of the plurality of capacitor structures CAP may pass through the interlayer dielectric 170 and the etch stop film 162 in the vertical direction (Z direction) and thus be connected to a corresponding conductive landing pad LP of the plurality of conductive landing pads LP. The etch stop film 162 may include a silicon nitride film, and the interlayer dielectric 170 may include a silicon oxide film.

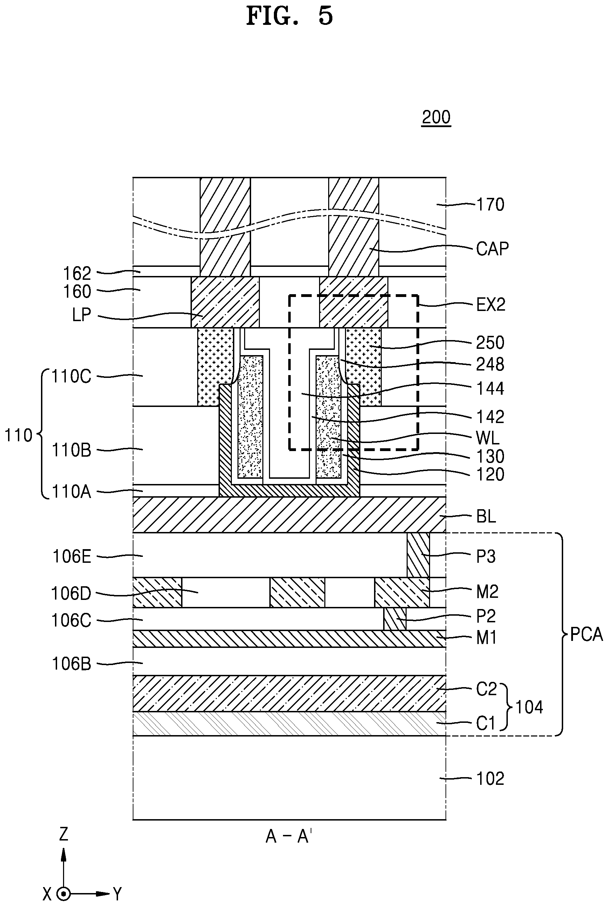

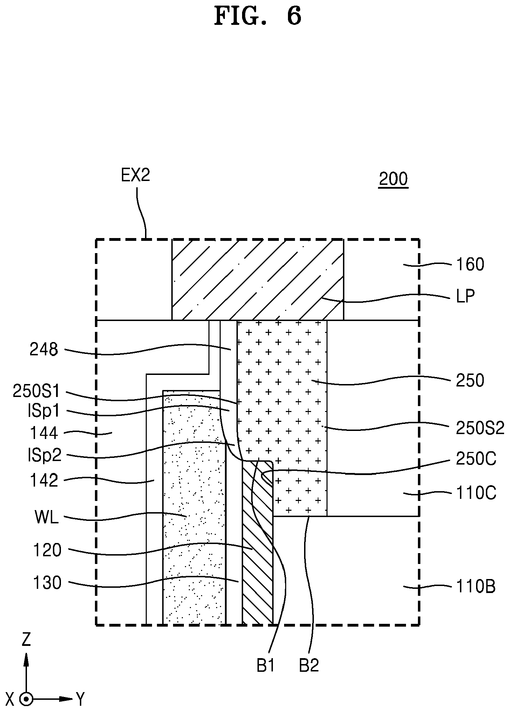

FIGS. 5 and 6 are diagrams illustrating a semiconductor device 200 according to some embodiments, and in particular, FIG. 5 is a cross-sectional view of a portion of the semiconductor device 200, which corresponds to the cross-section taken along the line A-A' of FIG. 1, and FIG. 6 is an enlarged cross-sectional view of a region EX2 of FIG. 5. In FIGS. 5 and 6, the same reference numerals as in FIGS. 1 to 4 respectively denote the same members, and here, repeated descriptions thereof are omitted for conciseness.

Referring to FIGS. 5 and 6, the semiconductor device 200 has substantially the same configuration as the semiconductor device 100 described with reference to FIGS. 1 to 4. However, the semiconductor device 200 includes a plurality of conductive contact patterns 250 and a plurality of insulating spacers 248.

The plurality of conductive contact patterns 250 may be respectively arranged on the plurality of channel layers 120. Each of the plurality of conductive contact patterns 250 may be connected to a corresponding channel layer 120 of the plurality of channel layers 120. Each of the plurality of conductive contact patterns 250 may include a first lower surface B1 contacting the upper surface of the vertical channel portion VC of the channel layer 120, a second lower surface B2 contacting the upper surface of the first mold insulating pattern 110B of the mold insulating pattern 110, and a surface 250C contacting a sidewall of the vertical channel portion VC of the channel layer 120.

Each of the plurality of conductive contact patterns 250 may include a first sidewall 250S1, which faces the word line WL in the second horizontal direction (Y direction), and a second sidewall 250S2, which faces the mold insulating pattern 110 in the second horizontal direction (Y direction). The first sidewall 250S1 and the second sidewall 250S2 of the conductive contact pattern 250 may be on opposite sides to each other in the second horizontal direction (Y direction). A constituent material of each of the plurality of conductive contact patterns 250 is substantially the same as the constituent material of each of the plurality of conductive contact patterns 150 described above.

The semiconductor device 200 may include a plurality of insulating spacers 248. Each of the plurality of insulating spacers 248 may be arranged between a corresponding conductive contact pattern 250 of the plurality of conductive contact patterns 250, and the word line WL adjacent to the corresponding conductive contact pattern 250. Each of the plurality of insulating spacers 248 may not include a portion between the corresponding conductive contact pattern 250 and the mold insulating pattern 110. In other words, the insulating spacer 248 may omit a portion between the second sidewall 250S2 of the corresponding conductive contact pattern 250 and the mold insulating pattern 110, such that the insulating spacer 248 is not provided between the second sidewall 250S2 of the corresponding conductive contact pattern 250 and the mold insulating pattern 110.

The plurality of insulating spacers 248 may be arranged one-by-one between the word line WL and the corresponding conductive contact pattern 250 in the second horizontal direction (Y direction). Each of the plurality of insulating spacers 248 may be arranged on a corresponding gate dielectric film 130. Each of the plurality of insulating spacers 248 may include a first portion ISp1 between the word line WL and the conductive contact pattern 250 and a second portion ISp2 between the gate dielectric film 130 and the conductive contact pattern 250. Thus, each of the plurality of insulating spacers 248 may surround only some of the sidewalls of the corresponding conductive contact pattern 250 such that each of the plurality of insulating spacers 248 is in contact with the first sidewall 250S1 of the conductive contact pattern 250 but is not in contact with the second sidewall 250S2 of the conductive contact pattern 250. The second sidewall 250S2 of the conductive contact pattern 250 may be in contact with the mold insulating pattern 110.

Each of the plurality of conductive contact patterns 250 may be in contact with the upper surface and the sidewall of a corresponding channel layer 120 of the plurality of channel layers 120. Each of the plurality of conductive contact patterns 250 may have a lower surface having a step. More specifically, each of the plurality of conductive contact patterns 250 may have a first lower surface B1, which is in contact with the upper surface of the vertical channel portion VC of the corresponding channel layer 120, and a second lower surface B2, which is in contact with the mold insulating pattern 110. A first vertical distance from the upper surface of the bit line BL, which overlaps the conductive contact pattern 250 in the vertical direction (Z direction), to the first lower surface B1 of the conductive contact pattern 250 may be different from a second vertical distance from the upper surface of the bit line BL to the second lower surface B2 of the conductive contact pattern 250. The second vertical distance may be less than the first vertical distance. As used herein, the term "vertical distance (or vertical length)" refers to a distance (or length) in the vertical direction (Z direction).

The first lower surface B1 of the conductive contact pattern 250 may be in contact with the upper surface of the vertical channel portion VC of the corresponding channel layer 120, and the second lower surface B2 of the conductive contact pattern 250 may be in contact with the upper surface of the first mold insulating pattern 110B of the mold insulating pattern 110. The second sidewall 250S2 of the conductive contact pattern 250 may be in contact with the second mold insulating pattern 110C of the mold insulating pattern 110. The conductive contact pattern 250 may have a surface that extends between the first lower surface B1 and the second lower surface B2 of the conductive contact pattern 250 and is in contact with the sidewall of the corresponding channel layer 120.

Each of the plurality of conductive contact patterns 250 may include a first portion, which is in contact with a corresponding insulating spacer 248 of the plurality of insulating spacers 248 and has a first lower surface B1 and a first sidewall 250S1, and a second portion, which is in contact with the mold insulating pattern 110 and has a second lower surface B2 and a second sidewall 250S2, and the vertical length of the first portion of each of the plurality of conductive contact patterns 250 may be less than the vertical length of the second portion of each of the plurality of conductive contact patterns 250. The vertical length of each of the plurality of insulating spacers 248 may be less than the vertical length of the second portion of each of the plurality of conductive contact patterns 250.

The second sidewall 250S2 of the conductive contact pattern 250 may be in contact with the second mold insulating pattern 110C of the mold insulating pattern 110. A constituent material of the insulating spacer 248 may be substantially the same as the constituent material of the insulating spacer 148 described with reference to FIGS. 2 and 4.

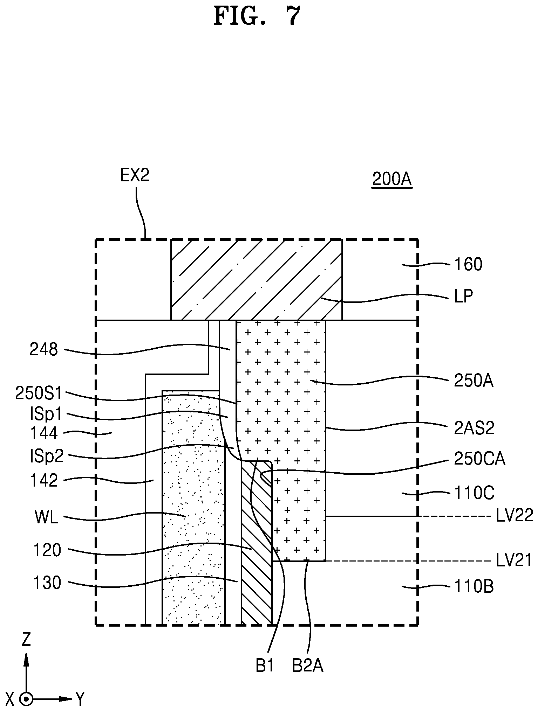

FIG. 7 is a cross-sectional view illustrating a semiconductor device 200A according to some embodiments. FIG. 7 illustrates an enlarged cross-sectional configuration of a portion of the semiconductor device 200A, which corresponds to the region EX2 of FIG. 5. In FIG. 7, the same reference numerals as in FIGS. 1 to 6 respectively denote the same members, and here, repeated descriptions thereof are omitted for conciseness.

Referring to FIG. 7, the semiconductor device 200A has substantially the same configuration as the semiconductor device 200 described with reference to FIGS. 5 and 6. However, the semiconductor device 200A includes a conductive contact pattern 250A.

The conductive contact pattern 250A has substantially the same configuration as the conductive contact pattern 250 described with reference to FIGS. 5 and 6. However, the conductive contact pattern 250A may have a first lower surface B1, which is in contact with the upper surface of the vertical channel portion VC of the channel layer 120, and a second lower surface B2A, which is in contact with the mold insulating pattern 110. The second lower surface B2A of the conductive contact pattern 250A may be a lowermost surface, which is closest to the substrate 102, in the conductive contact pattern 250A. A vertical level LV21 of the second lower surface B2A of the conductive contact pattern 250A may be closer to the substrate 102 (see FIG. 5) than a vertical level LV22 of an interface between the first mold insulating pattern 110B and the second mold insulating pattern 110C.

The first lower surface B 1 of the conductive contact pattern 250A may be in contact with the upper surface of the vertical channel portion VC of the channel layer 120, and the second lower surface B2A of the conductive contact pattern 250A may be in contact with the first mold insulating pattern 110B of the mold insulating pattern 110. A second sidewall 2AS2 of the conductive contact pattern 250A may be in contact with each of the first mold insulating pattern 110B and the second mold insulating pattern 110C of the mold insulating pattern 110. The conductive contact pattern 250A may have a surface 250CA that extends between the first lower surface B 1 and the second lower surface B2A of the conductive contact pattern 250A and is in contact with the sidewall of the channel layer 120.

The conductive contact pattern 250A may include a first portion, which is in contact with the insulating spacer 248 and has a first lower surface B1 and a first sidewall 250S 1, and a second portion, which is in contact with the mold insulating pattern 110 and has a second lower surface B2A and a second sidewall 2AS2, and the vertical length of the first portion of the conductive contact pattern 250A may be less than the vertical length of the second portion of the conductive contact pattern 250A. The vertical length of the insulating spacer 248 may be less than the vertical length of the second portion of the conductive contact pattern 250A.

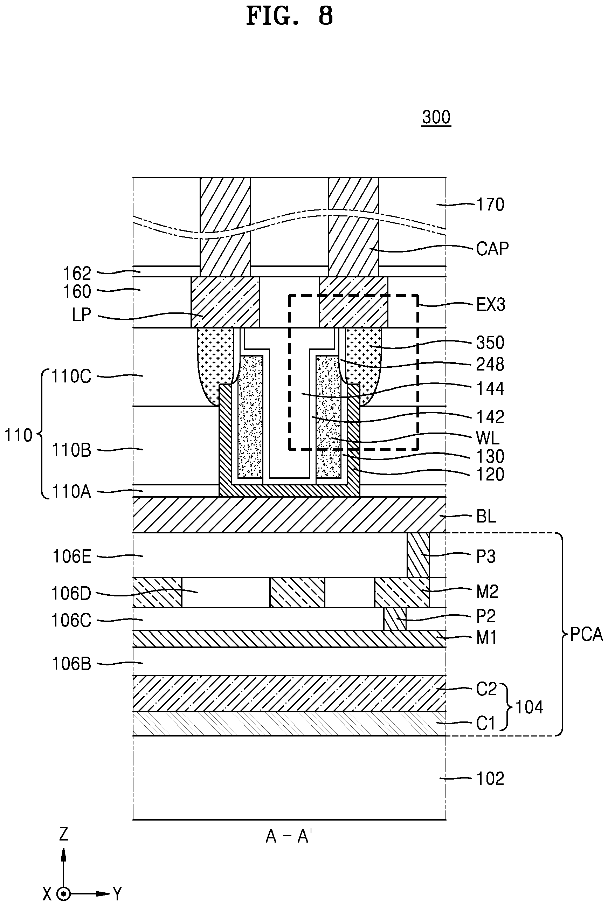

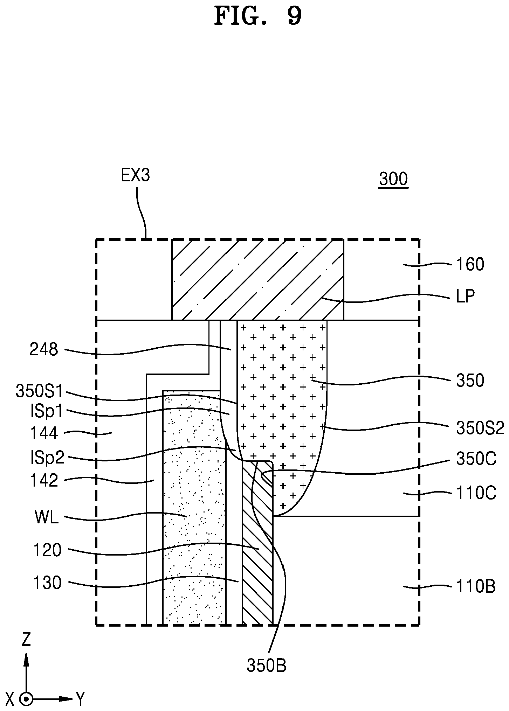

FIGS. 8 and 9 are diagrams each illustrating a semiconductor device 300 according to some embodiments, and in particular, FIG. 8 is a cross-sectional view of a portion of the semiconductor device 300, which corresponds to the cross-section taken along the line A-A' of FIG. 1, and FIG. 9 is an enlarged cross-sectional view of a region EX3 of FIG. 8. In FIGS. 8 and 9, the same reference numerals as in FIGS. 1 to 7 respectively denote the same members, and here, repeated descriptions thereof are omitted for conciseness.

Referring to FIGS. 8 and 9, the semiconductor device 300 has substantially the same configuration as the semiconductor device 100 described with reference to FIGS. 1 to 4. However, the semiconductor device 300 includes a plurality of conductive contact patterns 350 and a plurality of insulating spacers 248.

The plurality of conductive contact patterns 350 may be respectively arranged on the plurality of channel layers 120. Each of the plurality of conductive contact patterns 350 may be connected to a corresponding channel layer 120 of the plurality of channel layers 120. Each of the plurality of conductive contact patterns 350 may include a lower surface 350B, which is in contact with the upper surface of the vertical channel portion VC of the channel layer 120, and a surface 350C, which is in contact with the sidewall of the vertical channel portion VC of the channel layer 120.

Each of the plurality of conductive contact patterns 350 may include a first sidewall 350S1, which faces the word line WL in the second horizontal direction (Y direction), and a second sidewall 350S2, which faces the mold insulating pattern 110 in the second horizontal direction (Y direction). The first sidewall 350S1 and the second sidewall 350S2 of the conductive contact pattern 350 may be on opposite sides to each other in the second horizontal direction (Y direction). The first sidewall 350S1 of the conductive contact pattern 350 may be in contact with the insulating spacer 248. The second sidewall 350S2 of the conductive contact pattern 350 may be in contact with the mold insulating pattern 110. The second sidewall 350S2 of the conductive contact pattern 350 may include a curved surface that is convex toward the mold insulating pattern 110. A constituent material of each of the plurality of conductive contact patterns 350 may be substantially the same as the constituent material of each of the plurality of conductive contact patterns 150 described above.

Each of the plurality of insulating spacers 248 may include a first portion ISp1 between the word line WL and the conductive contact pattern 350 and a second portion ISp2 between the gate dielectric film 130 and the conductive contact pattern 350. Each of the plurality of insulating spacers 248 may surround only some of the sidewalls of the corresponding conductive contact pattern 350 such that each of the plurality of insulating spacers 248 is in contact with the first sidewall 350S1 of the conductive contact pattern 350 but is not in contact with the second sidewall 350S2 of the conductive contact pattern 350.

Each of the plurality of conductive contact patterns 350 may be in contact with the upper surface and the sidewall of a corresponding channel layer 120 of the plurality of channel layers 120. Each of the plurality of conductive contact patterns 350 may include a lower surface 350B that is in contact with the upper surface of the vertical channel portion VC of the channel layer 120. A lowermost point of the second sidewall 350S2 of the conductive contact pattern 350 may be closer to the substrate 102 than the lower surface 350B of the conductive contact pattern 350, which is in contact with the upper surface of the vertical channel portion VC. The second sidewall 350S2 of the conductive contact pattern 350 may be in contact with the second mold insulating pattern 110C of the mold insulating pattern 110. The conductive contact pattern 350 may have a surface that extends between the lower surface 350B of the conductive contact pattern 350 and the lowermost point of the second sidewall 350S2 of the conductive contact pattern 350 and is in contact with the sidewall of the channel layer 120.

Each of the plurality of conductive contact patterns 350 may include a first portion, which is in contact with a corresponding insulating spacer 248 of the plurality of insulating spacers 248 and has the lower surface 350B, and a second portion, which is in contact with the mold insulating pattern 110 and has the second sidewall 350S2 including the curved surface, and the vertical length of the first portion of each of the plurality of conductive contact patterns 350 may be less than the vertical length of the second portion of each of the plurality of conductive contact patterns 350. The vertical length of each of the plurality of insulating spacers 248 may be less than the vertical length of the second portion of each of the plurality of conductive contact patterns 350.

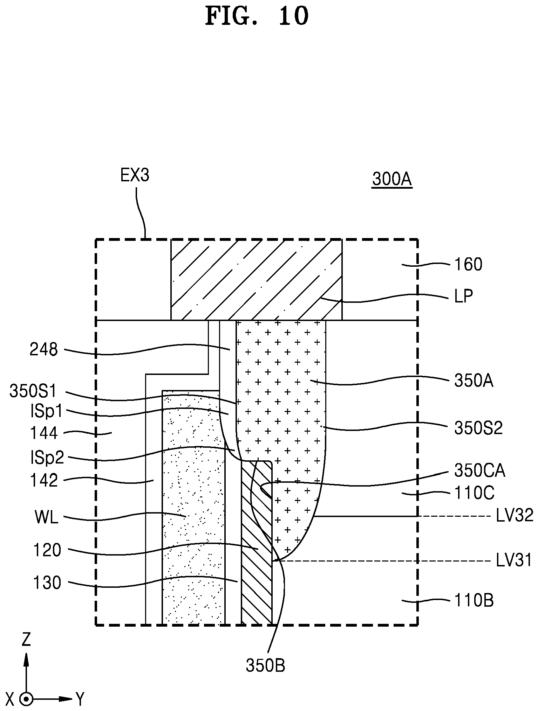

FIG. 10 is a cross-sectional view illustrating a semiconductor device 300A according to some embodiments. FIG. 10 illustrates an enlarged cross-sectional configuration of a portion of the semiconductor device 300A, which corresponds to the region EX3 of FIG. 8. In FIG. 10, the same reference numerals as in FIGS. 1 to 9 respectively denote the same members, and here, repeated descriptions thereof are omitted for conciseness.

Referring to FIG. 10, the semiconductor device 300A has substantially the same configuration as the semiconductor device 300 described with reference to FIGS. 8 and 9. However, the semiconductor device 300A includes a conductive contact pattern 350A.

The conductive contact pattern 350A has substantially the same configuration as the conductive contact pattern 350 described with reference to FIGS. 8 and 9. However, the conductive contact pattern 350A may have a lower surface 350B contacting the upper surface of the vertical channel portion VC of the channel layer 120, a first sidewall 350S1 contacting the insulating spacer 248, and a second sidewall 350S2 contacting the mold insulating pattern 110. The first sidewall 350S1 and the second sidewall 350S2 of the conductive contact pattern 350A may be on opposite sides to each other in the second horizontal direction (Y direction). The second sidewall 350S2 of the conductive contact pattern 350A may be in contact with the mold insulating pattern 110. The second sidewall 350S2 of the conductive contact pattern 350A may include a curved surface that is convex toward the mold insulating pattern 110. A constituent material of each of the plurality of conductive contact patterns 350A is substantially the same as the constituent material of each of the plurality of conductive contact patterns 150 described above.

Each of the plurality of insulating spacers 248 may include a first portion ISp1 between the word line WL and the corresponding conductive contact pattern 350A and a second portion ISp2 between the gate dielectric film 130 and the corresponding conductive contact pattern 350A. Each of the plurality of insulating spacers 248 may surround only some of the sidewalls of the conductive contact pattern 350A such that each of the plurality of insulating spacers 248 is in contact with the first sidewall 350S1 of the conductive contact pattern 350A but is not in contact with the second sidewall 350S2 of the conductive contact pattern 350A.

Each of the plurality of conductive contact patterns 350A may be in contact with the upper surface and the sidewall of a corresponding channel layer 120 of the plurality of channel layers 120. Each of the plurality of conductive contact patterns 350A may have a lower surface 350B, which is in contact with the upper surface of the vertical channel portion VC of the channel layer 120, and a surface 350CA, which is in contact with the sidewall of the vertical channel portion VC of the channel layer 120.

A lowermost point of the second sidewall 350S2 of the conductive contact pattern 350A may be closer to the substrate 102 than the lower surface 350B of the conductive contact pattern 350A, which is in contact with the upper surface of the vertical channel portion VC. The second sidewall 350S2 of the conductive contact pattern 350A may be in contact with the first mold insulating pattern 110B and the second mold insulating pattern 110C of the mold insulating pattern 110. The surface 350CA of the conductive contact pattern 350A may be in contact with the sidewall of the vertical channel portion VC of the channel layer 120 between the lower surface 350B and the lowermost point of the second sidewall 350S2 of the conductive contact pattern 350A.

Each of the plurality of conductive contact patterns 350A may include a first portion, which has the first sidewall 350S1 and the lower surface 350B, and a second portion, which is in contact with the mold insulating pattern 110 and has the second sidewall 350S2 including a curved surface, and the vertical length of the first portion of each of the plurality of conductive contact patterns 350A may be less than the vertical length of the second portion of each of the plurality of conductive contact patterns 350A. The vertical length of each of the plurality of insulating spacers 248 may be less than the vertical length of the second portion of each of the plurality of conductive contact patterns 350A.

A vertical level LV31 of a lowermost point of the second sidewall 350S2 of the conductive contact pattern 350A may be closer to the substrate 102 (see FIG. 8) than a vertical level LV32 of an interface between the first mold insulating pattern 110B and the second mold insulating pattern 110C. The second sidewall 350S2 of the conductive contact pattern 350A may be in contact with each of the first mold insulating pattern 110B and the second mold insulating pattern 110C of the mold insulating pattern 110. The conductive contact pattern 350A may have a surface 350CA that extends between the lower surface 350B and the lowermost point of the second sidewall 350S2 of the conductive contact pattern 350A and is in contact with the sidewall of the channel layer 120.

The conductive contact pattern 350A may include the first portion, which is in contact with the insulating spacer 248 and has the lower surface 350B and the first sidewall 350S1, and the second portion, which is in contact with the mold insulating pattern 110 and has the second sidewall 350S2, and the vertical length of the first portion of the conductive contact pattern 350A may be less than the vertical length of the second portion of the conductive contact pattern 350A.

Each of the semiconductor devices 100, 200, 200A, 300, and 300A described with reference to FIGS. 1 to 10 includes the insulating spacer 148 or 248 between the word line WL and the corresponding conductive contact pattern 150, 250, 250A, 350, or 350A. Therefore, according to the various embodiments described above, an electrical connection between the channel layer 120 and the conductive contact pattern 150, 250, 250A, 350, or 350A may be ensured and a short-circuit between other conductive components adjacent to the channel layer 120, for example, a short-circuit between the word line WL and the conductive contact pattern 150, 250, 250A, 350, or 350A, may be prevented. As described with reference to FIGS. 5 to 10, according to the various embodiments described above, each of the semiconductor devices 100, 200, 200A, 300, and 300A may have a structure in which the conductive contact pattern 150, 250, 250A, 350, or 350A is in contact with the upper surface and the sidewall of the channel layer 120. Therefore, according to the various embodiments described above, an increased contact area between the channel layer 120 and the conductive contact pattern 150, 250, 250A, 350, or 350A may be secured, thereby improving the reliability of each of the semiconductor devices 100, 200, 200A, 300, and 300A.

Next, a method of fabricating a semiconductor device, according to some embodiments, is described by taking a specific example.

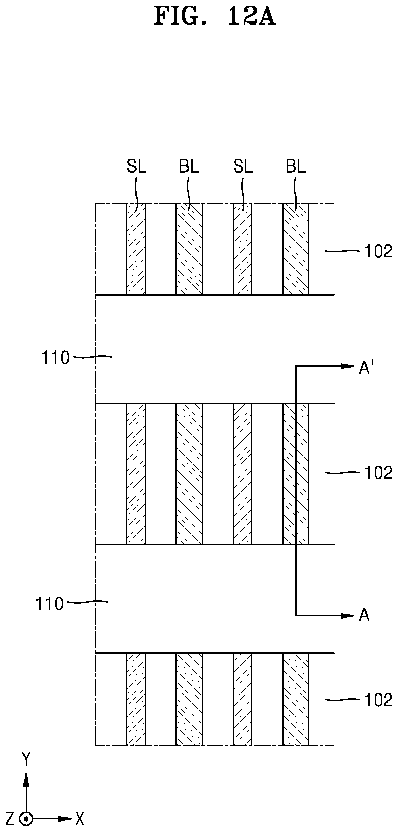

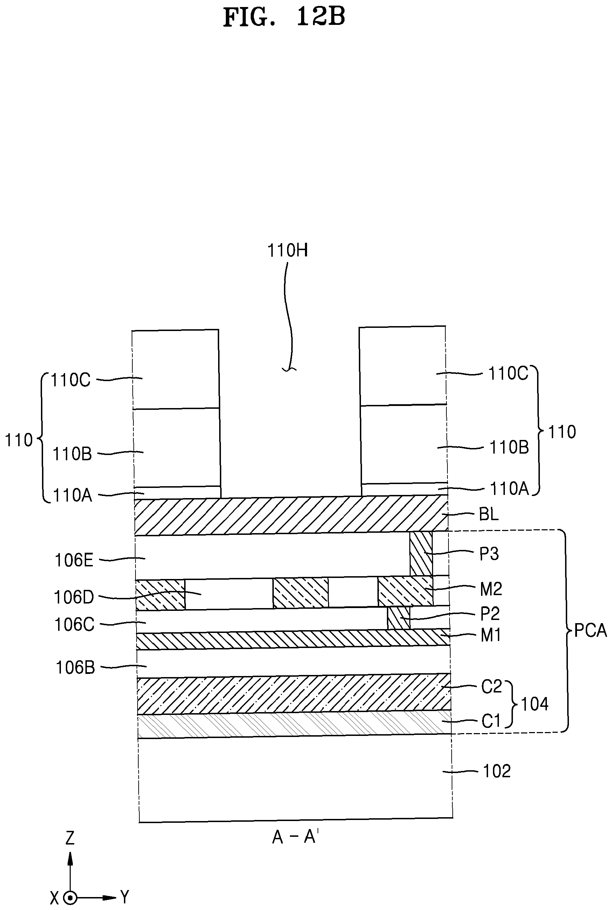

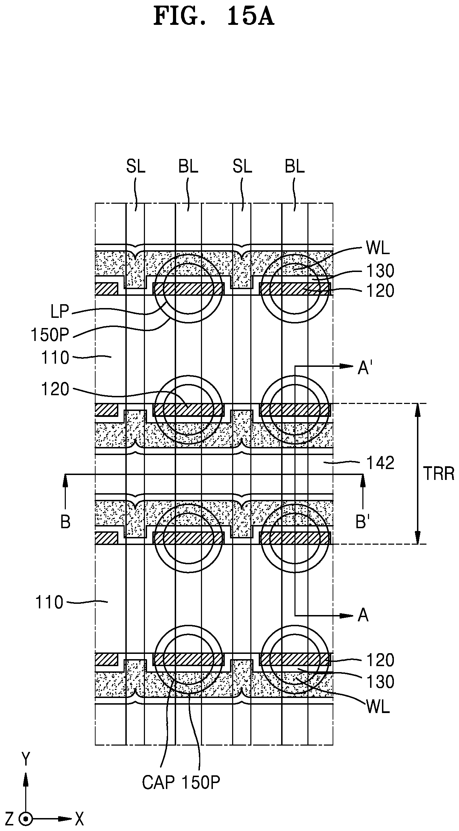

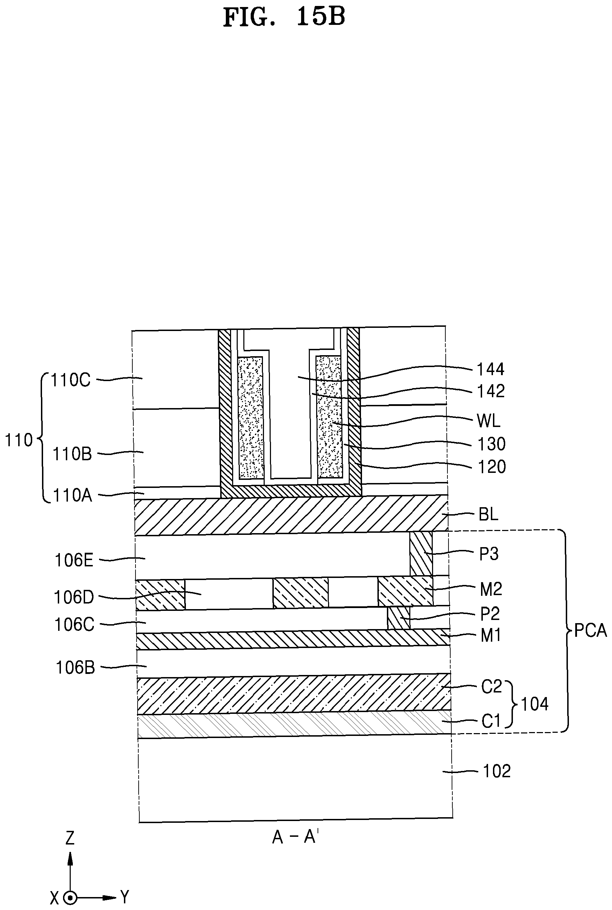

FIGS. 11A to 19B are diagrams respectively illustrating a sequence of processes of a method of fabricating a semiconductor device, according to some embodiments. More specifically, FIGS. 11A, 12A, and 15A are planar layout diagrams each illustrating some components of the semiconductor device according to the sequence of processes to describe the method of fabricating the semiconductor device. FIGS. 11B, 12B, 13, 14, 15B, 16A, 17A, 18A, and 19A are cross-sectional views each illustrating a portion of the semiconductor device, which corresponds to the cross-section taken along the line A-A' of FIG. 1, according to the sequence of processes, and in particular, FIG. 11B is a cross-sectional view of the semiconductor device of FIG. 11A, taken along the line A-A' of FIG. 11A, FIG. 12B is a cross-sectional view of the semiconductor device of FIG. 12A, taken along the line A-A' of FIG. 12A, and FIG. 15B is a cross-sectional view of the semiconductor device of FIG. 15A, taken along the line A-A' of FIG. 15A. FIGS. 16B, 17B, 18B, and 19B are enlarged cross-sectional views of regions EX1 of FIGS. 16A, 17A, 18A, and 19A, respectively. A method of fabricating the semiconductor device 100 shown in FIGS. 1 to 4 is described with reference to FIGS. 11A to 19B. In FIGS. 11A to 19B, the same reference numerals as in FIGS. 1 to 4 respectively denote the same members, and here, repeated descriptions thereof are omitted for conciseness.

Referring to FIGS. 11A and 11B, a plurality of peripheral circuits, which include the plurality of core circuits 104, the plurality of conductive plugs P1, P2, and P3, and the plurality of wiring layers M1 and M2, may be formed on the substrate 102, thereby forming the peripheral circuit structure PCA on the substrate 102. Next, the interlayer dielectric 106F (see FIG. 3) and the plurality of shielding structures SL, which each pass through the interlayer dielectric 106F, may be formed on the peripheral circuit structure PCA, followed by forming the interlayer dielectric 106G to cover the interlayer dielectric 106F and the plurality of shielding structures SL, and then, the plurality of bit lines BL may be formed through the interlayer dielectrics 106F and 106G (see FIG. 3).

Next, the lower mold pattern 110A, the first mold insulating pattern 110B, and the second mold insulating pattern 110C may be sequentially formed in the stated order on the plurality of bit lines BL, thereby forming the mold insulating pattern 110.

Referring to FIGS. 12A and 12B, a plurality of openings 110H may be formed in the mold insulating pattern 110. Some regions of each of the plurality of bit lines BL may be exposed by the plurality of openings 110H. Each of the plurality of openings 110H, which are formed in the mold insulating pattern 110, may provide a transistor region TRR (see FIG. 1).

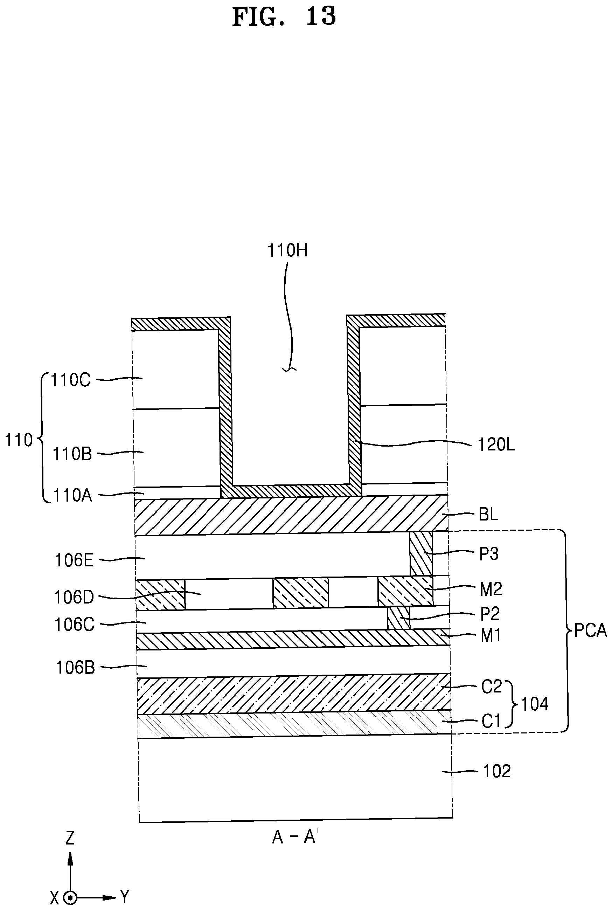

Referring to FIG. 13, a preliminary channel layer 120L may be formed to conformally cover surfaces exposed in the plurality of openings 110H, which are formed in the mold insulating pattern 110. In some embodiments, the preliminary channel layer 120L may include an oxide semiconductor layer. The oxide semiconductor layer may include one of IGZO, Sn-IGZO, IWO, IZO, ZTO, ZnO, YZO, IGSO, InO, SnO, TiO, ZnON, MgZnO, ZrInZnO, HfInZnO, SnInZnO, SiInZnO, GaZnSnO, ZrZnSnO, or a combination thereof. For example, in an embodiment, the preliminary channel layer 120L may include IGZO. In some embodiments, the preliminary channel layer 120L may include one of Si, Ge, SiGe, a Group III-V compound semiconductor, or a combination thereof. The Group III-V compound semiconductor may include, but is not limited to, GaAs or InSb.

In some embodiments, the preliminary channel layer 120L may be formed by at least one of a chemical vapor deposition (CVD) process, a low-pressure CVD process, a plasma-enhanced CVD process, a metal organic CVD (MOCVD) process, and an atomic layer deposition (ALD) process. In some embodiments, the preliminary channel layer 120L may have, but is not limited to, a thickness of about 1 nm to about 50 nm.

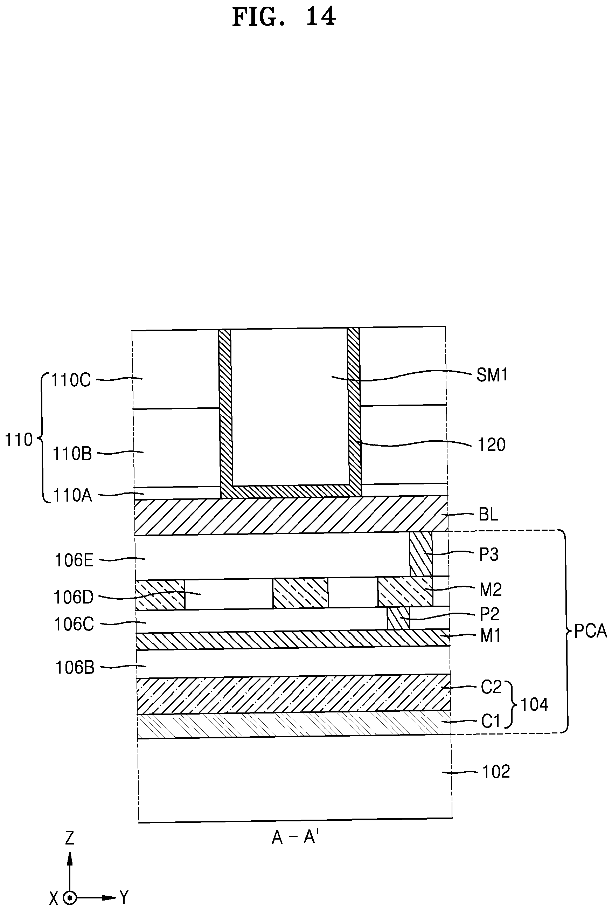

Referring to FIG. 14, in the resulting product of FIG. 13, a sacrificial pattern SM1 may be formed to cover the preliminary channel layer 120L, followed by etching the preliminary channel layer 120L by using the sacrificial pattern SM1 as an etch mask, thereby dividing the preliminary channel layer 120L into the plurality of channel layers 120.

Referring to FIGS. 15A and 15B, the upper surface of each of the plurality of channel layers 120 may be exposed by removing the sacrificial pattern SM1 from the resulting product of FIG. 14, and then, the plurality of gate dielectric films 130 and the plurality of word lines WL may be respectively formed in the plurality of openings 110H of the mold insulating pattern 110 to sequentially cover the plurality of channel layers 120 in the stated order.

In some embodiments, to form the plurality of gate dielectric films 130 and the plurality of word lines WL, the gate dielectric film 130 may be formed first to conformally cover exposed surfaces of each of the interlayer dielectric 106G and the plurality of channel layers 120, and then, the plurality of word lines WL may be formed on the gate dielectric film 130. During the process of forming the plurality of word lines WL, a portion of the gate dielectric film 130 between two word lines WL in the opening 110H may be removed. The upper surface of the channel layer 120 may be exposed between the two word lines WL in the opening 110H.

Next, the lower insulating liner 142 and the upper insulating partition wall 144 may be sequentially formed in the stated order on the two word lines WL in the opening 110H. After the upper insulating partition wall 144 is formed, the respective upper surfaces of the channel layer 120, the gate dielectric film 130, the lower insulating liner 142, the upper insulating barrier 144, and the mold insulating pattern 110 may form one flat surface.

Referring to FIGS. 16A and 16B, in the resulting product of FIGS. 15A and 15B, each of the plurality of channel layers 120 may be partially removed from the upper surface of each of the plurality of channel layers 120, whereby the height of each of the plurality of channel layers 120 may be reduced and a plurality of contact spaces CTH may be formed to respectively expose the upper surfaces of the plurality of channel layers 120. During the formation of the plurality of contact spaces CTH, a portion of the gate dielectric film 130 and a portion of the mold insulating pattern 110, which are exposed when the channel layer 120 is removed, may also be removed together with the channel layer 120. As a result, the width of each of the plurality of contact spaces CTH may be greater in the second horizontal direction (Y direction) than the width of the channel layer 120, and the word line WL adjacent to the channel layer 120 may be exposed by the contact space CTH. During the formation of the plurality of contact spaces CTH, to remove a portion of each of the plurality of channel layers 120 from the upper surface of each of the plurality of channel layers 120 and form the plurality of contact spaces CTH, a process including a wet process, a dry process, or a combination thereof may be used. For example, to remove a portion of each of the plurality of channel layers 120 from the upper surface of each of the plurality of channel layers 120 and form the plurality of contact spaces CTH, a wet process may be used.

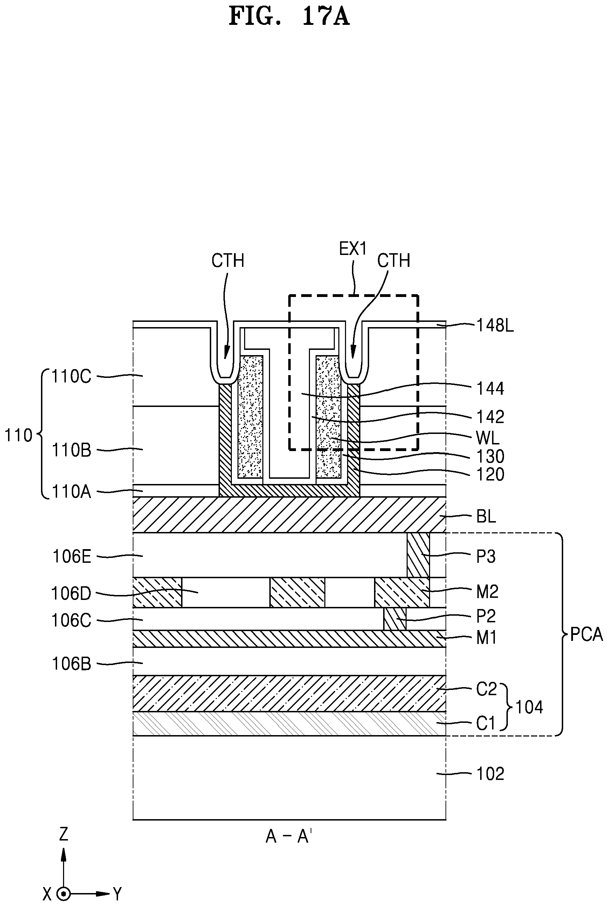

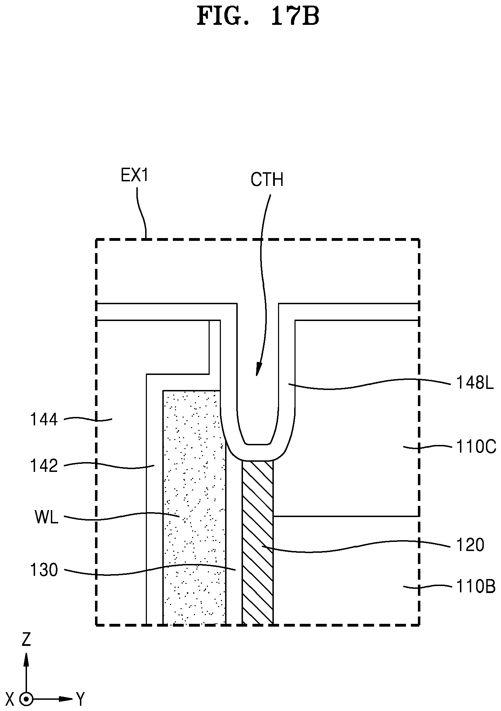

Referring to FIGS. 17A and 17B, an insulating spacer layer 148L may be formed on the resulting product of FIGS. 16A and 16B to conformally cover exposed surfaces of the resulting product of FIGS. 16A and 16B. The insulating spacer layer 148L may include one of silicon oxide, silicon nitride, SiCN, SiBN, SiON, SiOCN, SiBCN, SiOC, or a combination thereof. To form the insulating spacer layer 148L, an ALD process may be used.

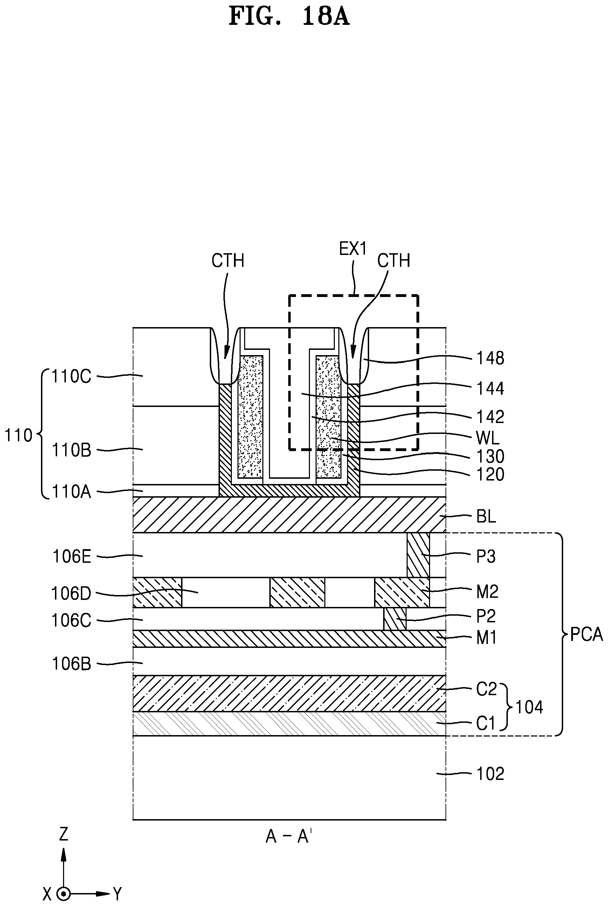

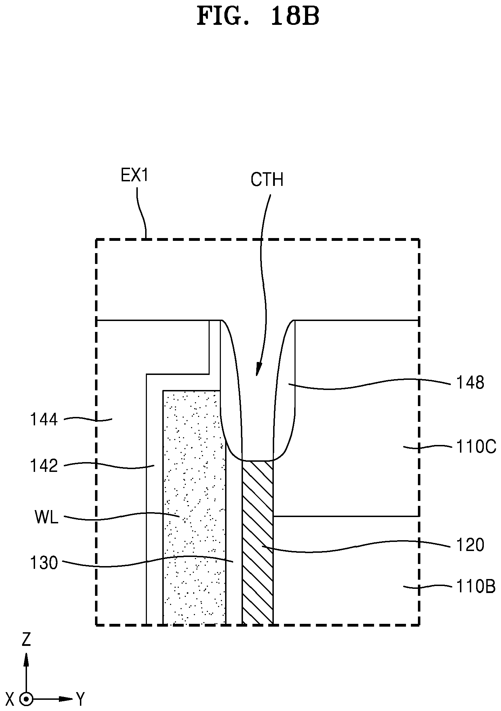

Referring to FIGS. 18A and 18B, in the resulting product of FIGS. 17A and 17B, the insulating spacer layer 148L may be anisotropically etched, whereby the upper surface of each of the plurality of channel layers 120 in the plurality of contact spaces CTH may be exposed and the plurality of insulating spacers 148 may be formed from the insulating spacer layer 148L to respectively cover inner sidewalls of the plurality of contact spaces CTH. After the plurality of insulating spacers 148 are formed, the word line WL in each of the plurality of contact spaces CTH may be covered by the insulating spacer 148 such that the word line WL is not exposed by the contact space CTH.

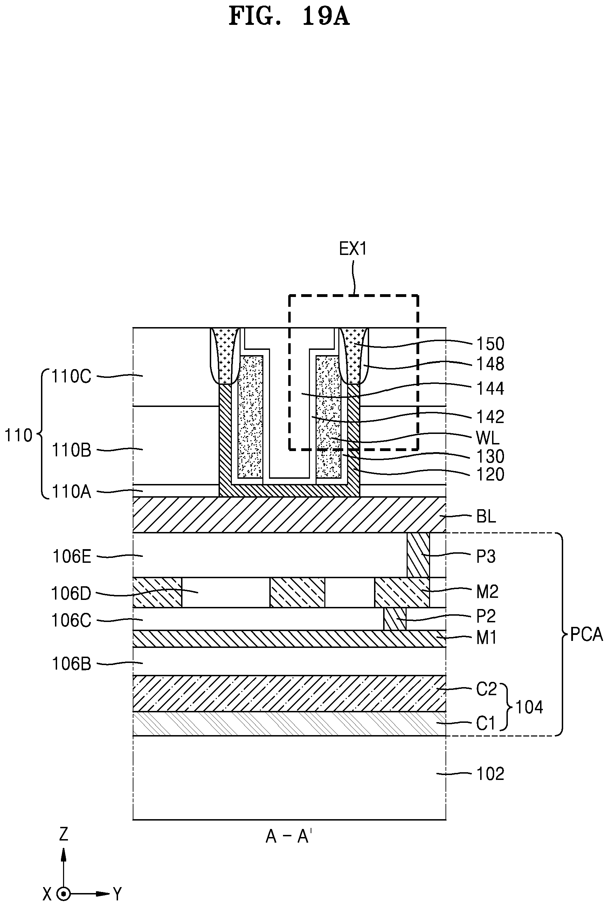

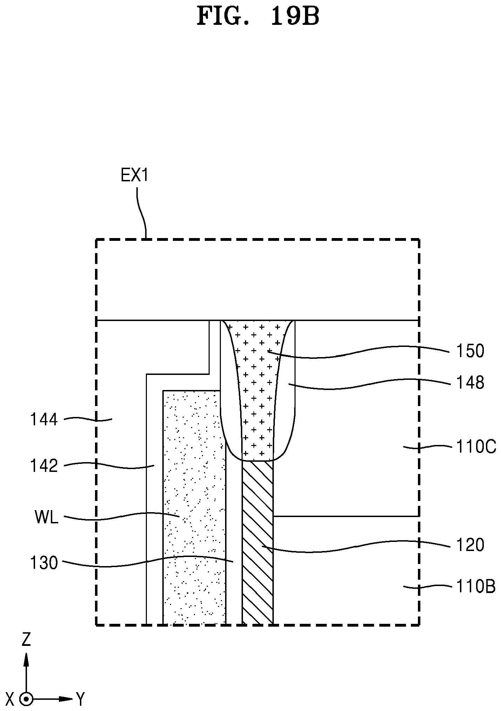

Referring to FIGS. 19A and 19B, the plurality of conductive contact patterns 150 may be formed to respectively fill the plurality of contact spaces CTH. To form the plurality of conductive contact patterns 150, a conductive layer may be formed on the resulting product of FIGS. 18A and 18B, and portions of the conductive layer, which are outside the plurality of contact spaces CTH, may be removed.

The conductive layer may include one of Ti, TiN, Ta, TaN, Mo, Ru, W, WN, TiSiN, WSiN, Ni, Ru, or a combination thereof. For example, the conductive layer may have a stack structure of a conductive barrier film including TiN and a conductive film including W.

Next, as shown in FIGS. 1 to 4, the isolation insulating film 160 and the plurality of conductive landing pads LP, which each pass through the isolation insulating film 160 in the vertical direction (Z direction), may be formed on the resulting product in which the plurality of conductive contact patterns 150 are formed. Next, as shown in FIGS. 2 and 3, the etch stop film 162 and the interlayer dielectric 170 may be formed on or over the resulting product in which the plurality of conductive landing pads LP are formed, followed by forming the plurality of capacitor structures CAP to be respectively connected to the plurality of conductive contact patterns 150 through the etch stop film 162 and the interlayer dielectric 170, thereby fabricating the semiconductor device 100 shown in FIGS. 1 to 4.

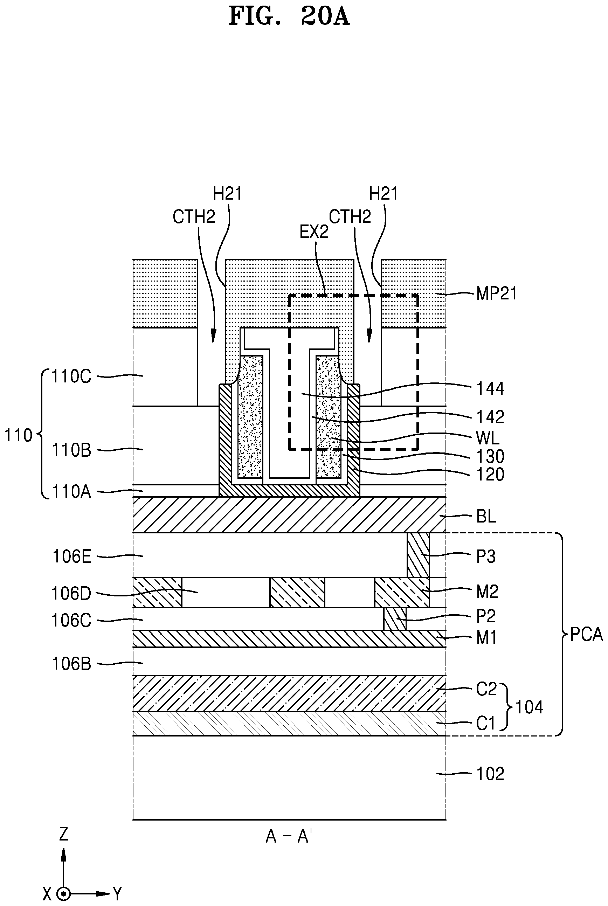

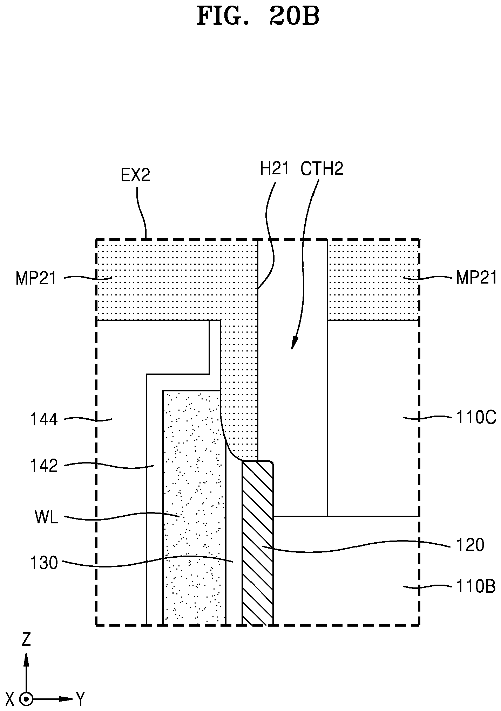

FIGS. 20A to 24B are diagrams respectively illustrating a sequence of processes of a method of fabricating a semiconductor device, according to some embodiments. More specifically, FIGS. 20A, 21A, 22A, 23A, and 24A are cross-sectional views each illustrating a portion of the semiconductor device, which corresponds to the cross-section taken along the line A-A' of FIG. 1, according to the sequence of processes, and FIGS. 20B, 21B, 22B, 23B, and 24B are enlarged cross-sectional views of regions EX2 of FIGS. 20A, 21A, 22A, 23A, and 24A, respectively. A method of fabricating the semiconductor device 200 shown in FIGS. 5 and 6 is described with reference to FIGS. 20A to 24B. In FIGS. 20A to 24B, the same reference numerals as in FIGS. 1 to 19B respectively denote the same members, and here, repeated descriptions thereof are omitted for conciseness.

Referring to FIGS. 20A and 20B, the processes described with reference to FIGS. 11A to 16B may be performed. Next, a first mask pattern MP21 may be formed on the resulting product of FIGS. 16A and 16B. The first mask pattern MP21 may be formed to fill a portion of each of the plurality of contact spaces CTH (see FIGS. 16A and 16B), which is adjacent to the word line WL, and to cover the upper surface of each of the lower insulating liner 142, the upper insulating partition wall 144, and the mold insulating pattern 110. The first mask pattern MP21 may have a plurality of openings H21 respectively connected with the plurality of contact spaces CTH. The first mask pattern MP21 may include a plurality of hardmask patterns each including one of a silicon oxide film, a silicon nitride film, or a combination thereof.

Next, portions of the mold insulating pattern 110, which are exposed by the plurality of openings H21 in the first mask pattern MP21 and by the plurality of contact spaces CTH, may be removed by an anisotropic dry etching process that uses the first mask pattern MP21 as an etch mask, thereby forming a plurality of expanded contact spaces CTH2 from the plurality of contact spaces CTH. Here, to form the plurality of expanded contact spaces CTH2, only the second mold insulating pattern 110C out of the first mold insulating pattern 110B and the second mold insulating pattern 110C, which are included in the mold insulating pattern 110, may be selectively removed.

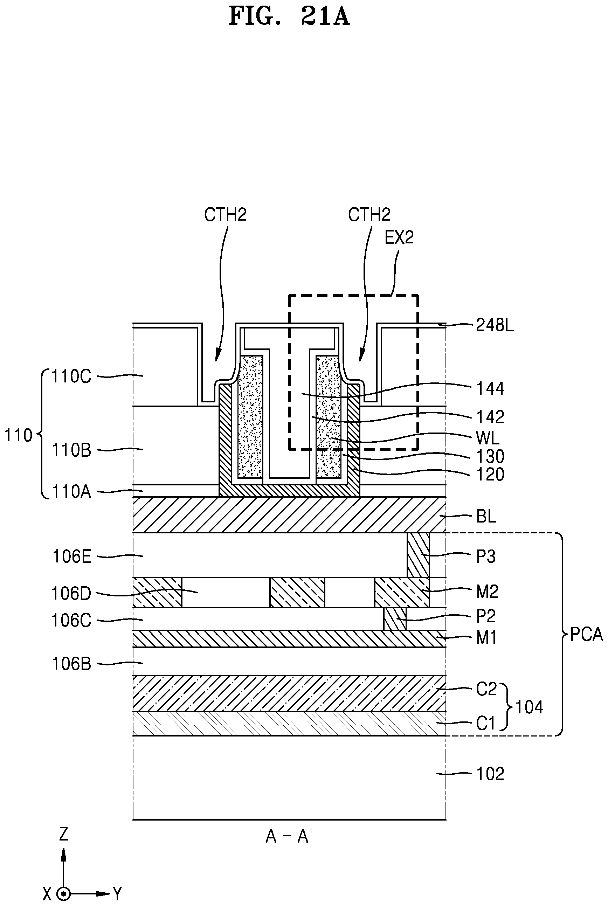

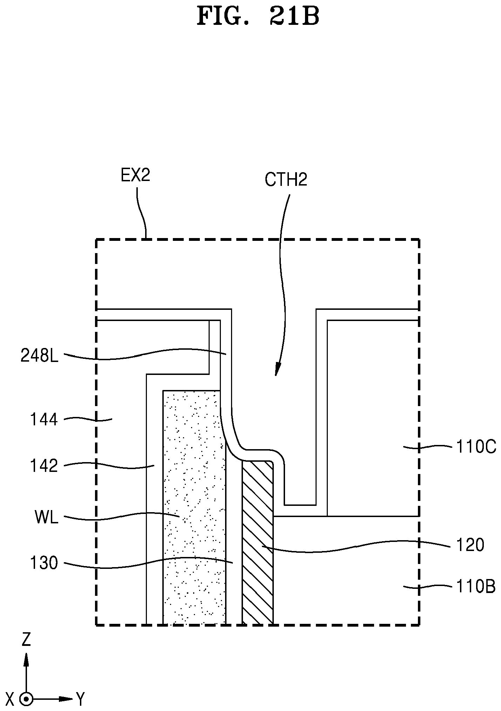

Referring to FIGS. 21A and 21B, the first mask pattern MP21 may be removed from the resulting product of FIGS. 20A and 20B, and then, an insulating spacer layer 248L may be formed on the resulting product, which is obtained after the removal of the first mask pattern MP21, by a similar method to the method of forming the insulating spacer layer 148L, which has been described with reference to FIGS. 17A and 17B. A constituent material of the insulating spacer layer 248L is substantially the same as the constituent material of the insulating spacer layer 148L, which has been described with reference to FIGS. 17A and 17B.

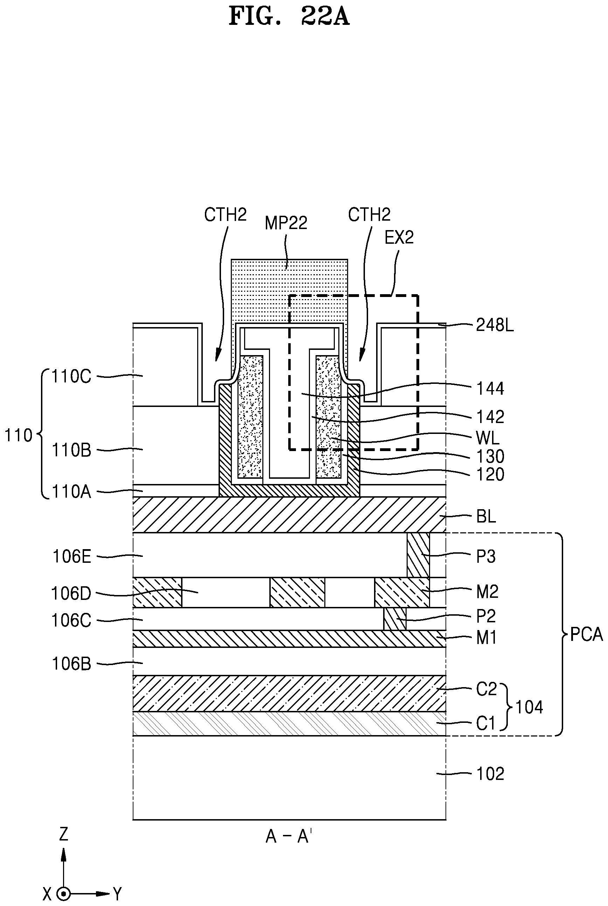

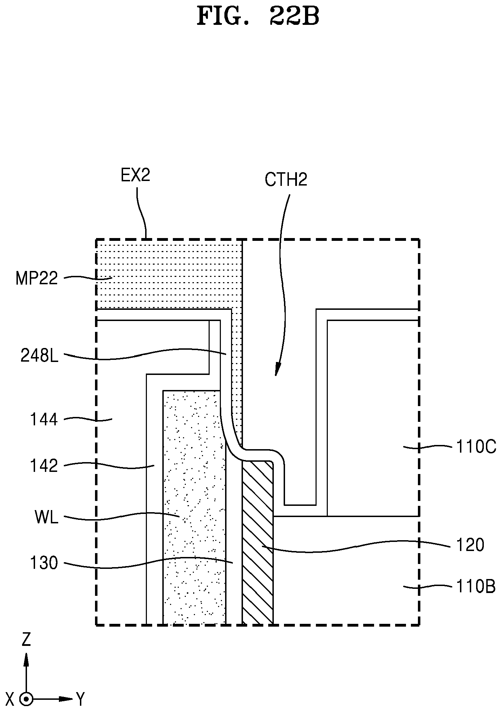

Referring to FIGS. 22A and 22B, a second mask pattern MP22 may be formed on the resulting product in which the insulating spacer layer 248L is formed. The second mask pattern MP22 may be formed on the insulating spacer layer 248L to fill a portion of each of the plurality of expanded contact spaces CTH2, which is adjacent to the word line WL, and to cover the upper surface of each of the lower insulating liner 142 and the upper insulating partition wall 144. Portions of the insulating spacer layer 248L, which are in the plurality of expanded contact spaces CTH2, and portions of the insulating spacer layer 248L, which cover the upper surface of the mold insulating pattern 110, may be exposed by the second mask pattern MP22.

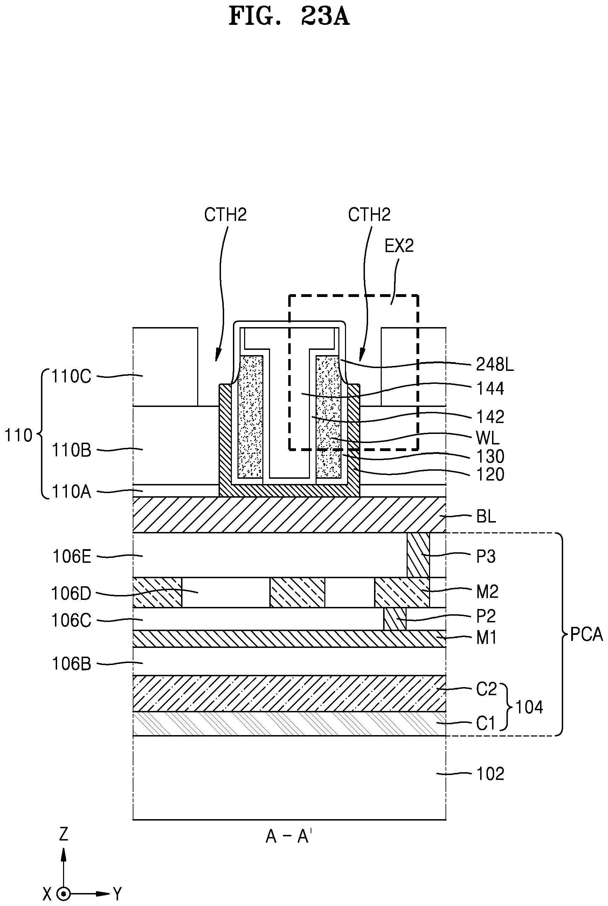

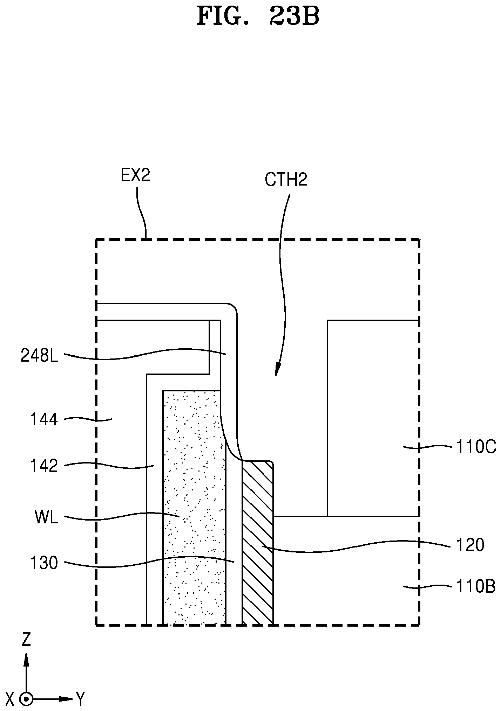

Referring to FIGS. 23A and 23B, the exposed portions of the insulating spacer layer 248L may be removed from the resulting product of FIGS. 21A and 21B by using the second mask pattern MP22 as an etch mask. Next, the second mask pattern MP22 may be removed. In the resulting product of FIGS. 23A and 23B, the word line WL in each of the plurality of expanded contact spaces CTH2 may be covered by the insulating spacer layer 248L such that the word line WL is not exposed by each of the plurality of expanded contact spaces CTH2.

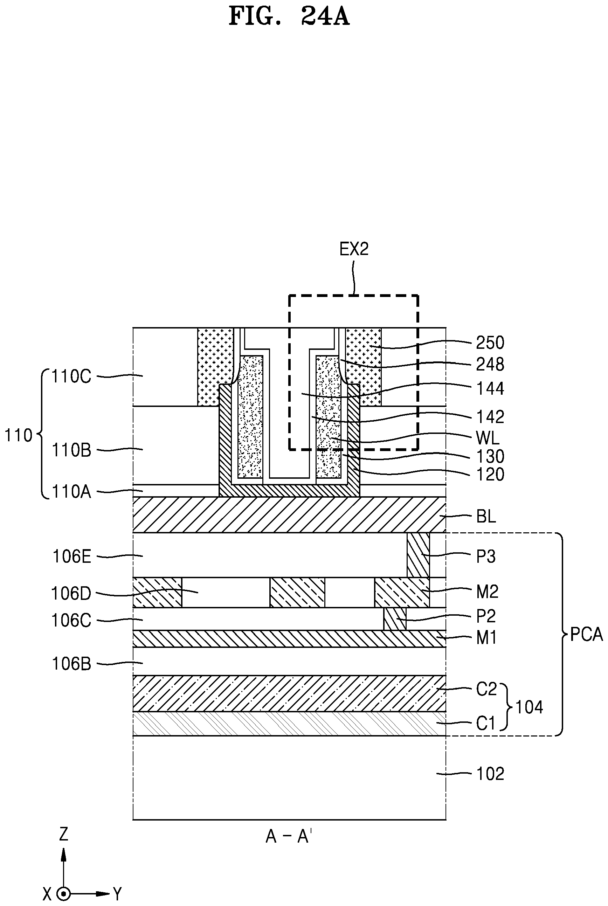

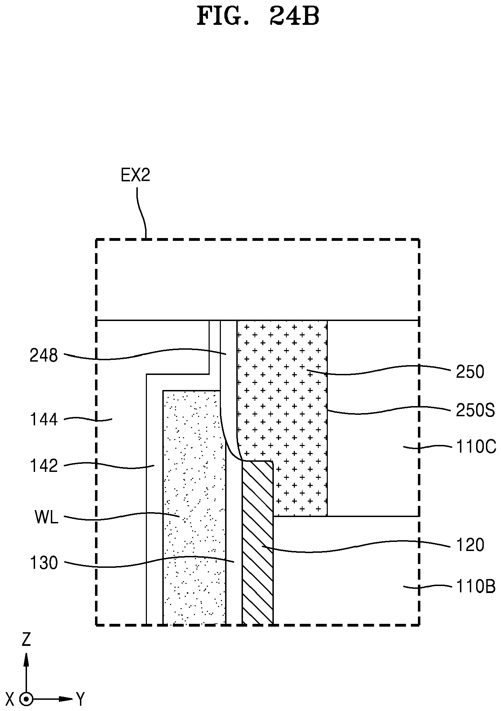

Referring to FIGS. 24A and 24B, in the resulting product of FIGS. 23A and 23B, the plurality of conductive contact patterns 250 may be formed to respectively fill the plurality of expanded contact spaces CTH2, by a similar method to the method described regarding the formation of the plurality of conductive contact patterns 150 with reference to FIGS. 19A and 19B. During the formation of the plurality of conductive contact patterns 250, portions of the insulating spacer layer 248L, which cover the upper surface of the mold insulating pattern 110, may be removed, and as a result, the plurality of insulating spacers 248 may be respectively obtained from portions of the insulating spacer layer 248L, which are in the plurality of expanded contact spaces CTH2.

After the plurality of conductive contact patterns 250 are formed, a structure, in which the upper surface of the mold insulating pattern 110 is exposed and the insulating spacer 248 is arranged between the conductive contact pattern 250 and the word line WL, may be obtained.

Next, as shown in FIGS. 1 to 4, the isolation insulating film 160 and the plurality of conductive landing pads LP, which each pass through the isolation insulating film 160 in the vertical direction (Z direction), may be formed on the resulting product in which the plurality of conductive contact patterns 250 are formed. Next, as shown in FIGS. 2 and 3, the etch stop film 162 and the interlayer dielectric 170 may be formed on or over the resulting product in which the plurality of conductive landing pads LP are formed, followed by forming the plurality of capacitor structures CAP to be respectively connected to the plurality of conductive contact patterns 150 through the etch stop film 162 and the interlayer dielectric 170, thereby fabricating the semiconductor device 200 shown in FIGS. 5 and 6.

To fabricate the semiconductor device 200A shown in FIG. 7, similar processes to those described with reference to FIGS. 20A to 24B may be performed. However, in the process described with reference to FIGS. 20A and 20B, when the portions of the mold insulating pattern 110, which are exposed by the plurality of openings H21 in the first mask pattern MP21 and by the plurality of contact spaces CTH, are removed by an anisotropic dry etching process, the second mold insulating pattern 110C as well as the first mold insulating pattern 110B of the mold insulating pattern 110 may be partially etched, thereby forming an expanded contact space that has a greater length in the vertical direction (Z direction) than the expanded contact space CTH2. Next, similar processes to those described with reference to FIGS. 21A to 24B may be performed.

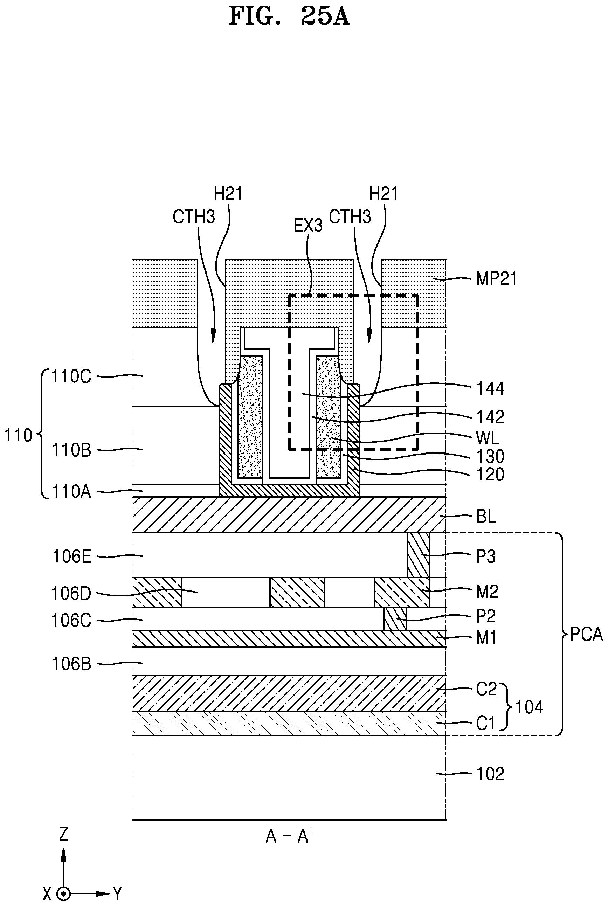

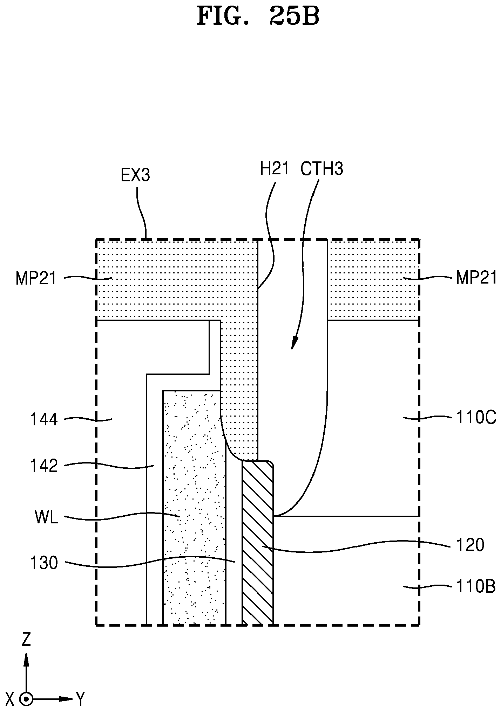

FIGS. 25A and 25B are diagrams respectively illustrating a sequence of processes of a method of fabricating a semiconductor device, according to some embodiments. More specifically, FIG. 25A is a cross-sectional view illustrating some processes regarding a portion of the semiconductor device, which corresponds to the cross-section taken along the line A-A' of FIG. 1, and FIG. 25B is an enlarged cross-sectional view of a region EX3 of FIG. 25A. A method of fabricating the semiconductor device 300 shown in FIGS. 8 and 9 is described with reference to FIGS. 25A and 25B. In FIGS. 25A and 25B, the same reference numerals as in FIGS. 1 to 24B respectively denote the same members, and here, repeated descriptions thereof are omitted.

Referring to FIGS. 25A and 25B, after the processes described with reference to FIGS. 11A to 16B are performed, the first mask pattern MP21 may be formed on the resulting product of FIGS. 16A and 16B by the same method as described with reference to FIGS. 20A and 20B.

Next, portions of the mold insulating pattern 110, which are exposed by the plurality of openings H21 in the first mask pattern MP21 and by the plurality of contact spaces CTH, may be removed by an isotropic wet etching process, thereby forming a plurality of expanded contact spaces CTH3 from the plurality of contact spaces CTH. Here, to form the plurality of expanded contact spaces CTH3, only the second mold insulating pattern 110C out of the first mold insulating pattern 110B and the second mold insulating pattern 110C of the mold insulating pattern 110 may be selectively removed.

Next, the processes described with reference to FIGS. 21A to 24B may be performed on the resulting product of FIGS. 25A and 25B, thereby fabricating the semiconductor device 300 shown in FIGS. 8 and 9.

To fabricate the semiconductor device 300A shown in FIG. 10, similar processes to those described with reference to FIGS. 25A and 25B may be performed. However, when the portions of the mold insulating pattern 110, which are exposed by the plurality of openings H21 in the first mask pattern MP21 and by the plurality of contact spaces CTH, are removed by an isotropic wet etching process, the second mold insulating pattern 110C as well as the first mold insulating pattern 110B of the mold insulating pattern 110 may be partially etched, thereby forming an expanded contact space that has a greater length in the vertical direction (Z direction) than the expanded contact space CTH3. Next, similar processes to those described with reference to FIGS. 21A to 24B may be performed.

Heretofore, although the examples of the methods of fabricating the semiconductor devices 100, 200, 200A, 300, and 300A shown in FIGS. 1 to 10 have been described with reference to FIGS. 11A to 25B, semiconductor devices having various structures modified and changed from the semiconductor devices 100, 200, 200A, 300, and 300A shown in FIGS. 1 to 10 may be fabricated by making various modifications and changes to the examples described with reference to FIGS. 11A to 25B without departing from the spirit and scope of the present disclosure and the appended claims.

While various embodiments have been particularly shown and described with reference to the drawings, it will be understood that various changes in form and details may be made therein without departing from the scope of the following claims.

## Claims

1. A semiconductor device comprising:
an upper conductive line extending in a first horizontal direction over a substrate;
a channel layer facing the upper conductive line in a second horizontal direction that is perpendicular to the first horizontal direction;
a gate dielectric film between the channel layer and the upper conductive line;
a conductive contact pattern comprising a lower surface, which is in contact with an upper surface of the channel layer, and sidewalls including a first sidewall, which faces the upper conductive line in the second horizontal direction; and
an insulating spacer comprising a first portion between the upper conductive line and the conductive contact pattern in the second horizontal direction.

2. The semiconductor device of claim 1, wherein the sidewalls of the conductive contact pattern further comprise a second sidewall, which is on an opposite side to the first sidewall in the second horizontal direction, and
the insulating spacer surrounds the sidewalls of the conductive contact pattern such that the insulating spacer is in contact with each of the first sidewall and the second sidewall of the conductive contact pattern.

3. The semiconductor device of claim 1, wherein the sidewalls of the conductive contact pattern further comprise a second sidewall, which is on an opposite side to the first sidewall in the second horizontal direction, and
the insulating spacer surrounds only some of the sidewalls of the conductive contact pattern such that the insulating spacer is in contact with the first sidewall of the conductive contact pattern and is not in contact with the second sidewall of the conductive contact pattern.

4. The semiconductor device of any preceding claim, wherein the insulating spacer further comprises a second portion between the gate dielectric film and the conductive contact pattern.

5. The semiconductor device of any preceding claim, wherein the conductive contact pattern further comprises a surface that is in contact with a sidewall of the channel layer.

6. The semiconductor device of any preceding claim, further comprising a mold insulating pattern arranged over the substrate and defining a transistor region,
wherein the channel layer comprises a vertical channel portion, which is in contact with the mold insulating pattern and extends in a vertical direction in the transistor region, and
the conductive contact pattern is spaced apart from the mold insulating pattern in the second horizontal direction with the insulating spacer therebetween.

7. The semiconductor device of any one of claims 1 to 5, further comprising a mold insulating pattern arranged over the substrate and defining a transistor region,
wherein the channel layer comprises a vertical channel portion, which is in contact with the mold insulating pattern and extends in a vertical direction in the transistor region, and
the conductive contact pattern is in contact with the mold insulating pattern.

8. The semiconductor device of claim 1, further comprising a mold insulating pattern arranged over the substrate and defining a transistor region,
wherein a sidewall of the sidewalls of the conductive contact pattern, which faces the mold insulating pattern, comprises a curved surface that is convex toward the mold insulating pattern.

9. The semiconductor device of claim 1, further comprising a mold insulating pattern arranged over the substrate and defining a transistor region,
wherein the mold insulating pattern comprises a first mold insulating pattern and a second mold insulating pattern, which are sequentially stacked in a vertical direction and comprise different materials from each other, and
the conductive contact pattern is in contact with each of the first mold insulating pattern and the second mold insulating pattern.

10. The semiconductor device of any preceding claim, wherein the channel layer comprises one of InGaZnO (IGZO), Sn-IGZO, InWO (IWO), InZnO (IZO), ZnSnO (ZTO), ZnO, yttrium-doped zinc oxide (YZO), InGaSiO (IGSO), InO, SnO, TiO, ZnON, MgZnO, ZrInZnO, HflnZnO, SnInZnO, SiInZnO, GaZnSnO, ZrZnSnO, Si, Ge, SiGe, a Group III-V compound semiconductor, or a combination thereof.

11. The semiconductor device of any preceding claim, wherein the insulating spacer comprises one of silicon oxide, silicon nitride, SiCN, SiBN, SiON, SiOCN, SiBCN, SiOC, or a combination thereof.

12. The semiconductor device of any preceding claim, wherein the conductive contact pattern comprises one of Ti, TiN, Ta, TaN, W, WN, TiSiN, WSiN, Ni, Ru, or a combination thereof.

13. A semiconductor device comprising:
a plurality of lower conductive lines arranged parallel to each other over a substrate;
a mold insulating pattern arranged on the plurality of lower conductive lines and defining a transistor region that extends in a first horizontal direction;
a plurality of channel layers arranged in a line in the first horizontal direction in the transistor region, each of the plurality of channel layers comprising a vertical channel portion that faces a sidewall of the mold insulating pattern;
a plurality of upper conductive lines respectively arranged over the plurality of channel layers, each of the plurality of upper conductive lines having a sidewall that faces the vertical channel portion of a corresponding channel layer of the plurality of channel layers;
a plurality of gate dielectric films respectively between the plurality of channel layers and the plurality of upper conductive lines;
a plurality of conductive contact patterns connected to the vertical channel portion of a corresponding channel layer of the plurality of channel layers; and
a plurality of insulating spacers respectively on the plurality of gate dielectric films,
wherein each of the plurality of conductive contact patterns comprises a lower surface, which is in contact with an upper surface of the vertical channel portion, and a first sidewall facing a corresponding upper conductive line of the plurality of upper conductive lines, in a second horizontal direction that is perpendicular to the first horizontal direction, and
each of the plurality of insulating spacers comprises a first portion between a corresponding upper conductive line of the plurality of upper conductive lines and a corresponding conductive contact pattern of the plurality of conductive contact patterns in the second horizontal direction.

14. The semiconductor device of claim 13, wherein each of the plurality of insulating spacers further comprises a second portion between the corresponding conductive contact pattern and the mold insulating pattern in the second horizontal direction.

15. The semiconductor device of claim 13, wherein each of the plurality of insulating spacers is not disposed between the corresponding conductive contact pattern and the mold insulating pattern in the second horizontal direction.
